# EUROPEAN PATENT APPLICATION

(11) **EP 4 343 839 A1**
(43) Date of publication of application: **27.03.2024**
(21) Application number: 22804497.0
(22) Date of filing: 20.04.2022
(51) Int. Cl.: H01L 25/065, H01L 25/07, H01L 25/18, H01L 25/16, H01L 33/62

(54) **SEMICONDUCTOR DEVICE AND METHOD FOR PRODUCING SEMICONDUCTOR DEVICE**

(30) Priority: 20.05.2021 JP 2021085191
(71) Applicant: Stanley Electric Co. Ltd., Tokyo 153-8636 (JP)
(72) Inventor: YASUDA, Yoshiaki, Tokyo 153-8636 (JP); CHIBA, Hirofumi, Tokyo 153-8636 (JP)
(74) Representative: Carstens, Dirk Wilhelm
(86) International application number: PCT/JP2022/018309
(87) International publication number: WO 2022/244583

(57) **Abstract**

A light emitting device of the present invention includes a substrate, a semiconductor element, a first external electrode, and a second external electrode. The substrate has a first conductivity type and contains a single-crystal silicon. The substrate has an upper surface and a lower surface on which thermally-oxidized films are formed. A first opening portion and a second opening portion are formed to be mutually spaced in the thermally-oxidized film formed on the lower surface. The substrate includes a diode structure unit that includes a first well region and a second well region. The first well region is formed in a first region along the lower surface, is exposed at the first opening portion, and has a second conductivity type different from the first conductivity type. The second well region is formed in a second region along the lower surface in the first region, is exposed at the second opening portion, and has the first conductivity type. The semiconductor element is disposed on the substrate and includes a semiconductor layer. The first external electrode is formed on a lower surface of the thermally-oxidized film and in contact with the first well region at the first opening portion. The second external electrode is formed on the lower surface of the thermally-oxidized film, spaced from the first external electrode, and in contact with the second well region at the second opening portion. The second well region extends to the first opening portion side exceeding a middle line between the first opening portion and the second opening portion along the lower surface of the substrate.

## Description

### BACKGROUND OF THE INVENTION

### 1. Field of the Invention

The present invention relates to a semiconductor device and a method for manufacturing the semiconductor device.

### 2. Background Art

Recently, in semiconductor devices and the like that include semiconductor elements, such as a light-emitting element, a light-emitting device that includes an overvoltage protection element inside a mounting substrate on which the semiconductor element is mounted is becoming popular.

For example, JP-A-2008-21987 discloses a semiconductor device that includes a semiconductor substrate and a zener diode. P-type impurities are preliminarily diffused in the whole region of the semiconductor substrate, and the semiconductor substrate is made of silicon (that is, a P-type silicon semiconductor substrate). The zener diode is a semiconductor element, and includes an N layer in which N-type impurities are injected and diffused in a mounting surface side on which a light-emitting element is mounted, which is an upper plane side, inside the semiconductor substrate. In the semiconductor device, the light-emitting element is connected to a pair of upper plane side wiring layers formed on the upper plane of the semiconductor substrate via bumps made of gold (Au) in an aspect of flip chip.

### SUMMARY OF THE INVENTION

Generally, an inter-electrode distance between an anode and a cathode of a semiconductor element, such as a light-emitting element, is smaller than an inter-electrode distance of mounting electrodes formed on an outer side of the semiconductor device. Therefore, in JP-A-2008-21987, when the upper plane side wiring layer of the semiconductor substrate is joined to the light-emitting element with a molten metal, such as a gold-tin (AuSn) alloy, as a bonding layer, at a heating treatment in the joining, the melted bonding layer on the electrode of one polarity contacts a portion of the other polarity of the semiconductor element (zener diode) formed in the upper plane side inside the semiconductor substrate, thus possibly causing a short circuit of the semiconductor device.

In JP-A-2008-21987, the whole region of the semiconductor substrate functions as a P layer of the semiconductor element (zener diode). Accordingly, when an overvoltage is applied to the semiconductor device mounted on the mounting substrate, a current caused by an electron avalanche breakdown of the semiconductor element (zener diode) is transmitted to another semiconductor element or semiconductor device adjacent to the semiconductor device on the mounting substrate as a leak current, thus possibly causing an operational failure.

The present invention is made in consideration of the above-described point, and it is an object of the present invention to provide a semiconductor device capable of avoiding a short circuit caused by a molten metal at a heating treatment of a bonding layer, and capable of suppressing a leak current to another adjacent semiconductor device when an overvoltage is applied after being mounted to a mounting substrate, and provide a method for manufacturing the semiconductor device.

A semiconductor device according to the present invention includes a substrate, a semiconductor element, a first external electrode, and a second external electrode. The substrate has a first conductivity type and made of a single-crystal silicon. The substrate has an upper surface and a lower surface on which thermally-oxidized films are formed. A first opening portion and a second opening portion are formed to be mutually spaced in the thermally-oxidized film formed on the lower surface. The substrate includes a diode structure unit that includes a first well region and a second well region. The first well region is formed in a first region along the lower surface and is exposed at the first opening portion. The first well region has a second conductivity type different from the first conductivity type. The second well region is formed in a second region along the lower surface in the first region and is exposed at the second opening portion. The second well region has the first conductivity type. The semiconductor element is disposed on the substrate and includes a semiconductor layer. The first external electrode is formed on a lower surface of the thermally-oxidized film and in contact with the first well region at the first opening portion. The second external electrode is formed on the lower surface of the thermally-oxidized film, spaced from the first external electrode, and in contact with the second well region at the second opening portion. The second well region extends to the first opening portion side exceeding a middle line between the first opening portion and the second opening portion along the lower surface of the substrate.

A method for manufacturing a semiconductor device according to the present invention includes: a step of preparing a substrate having a first conductivity type and made of a single-crystal silicon; a first diffusion step of forming a first well region having a second conductivity type different from the first conductivity type in a first region along a lower surface of the substrate; a second diffusion step of forming a second well region having the first conductivity type in a second region along the lower surface of the substrate in the first region; a thermally-oxidized film formation step of forming a thermally-oxidized film on the lower surface of the substrate, the thermally-oxidized film being provided with a first opening portion at which the first well region is exposed and a second opening portion at which the second well region is exposed; and an external electrode formation step of forming a first external electrode and a second external electrode on a lower surface of the thermally-oxidized film, the first external electrode being in contact with the first well region at the first opening portion, and the second external electrode being spaced from the first external electrode and in contact with the second well region at the second opening portion. In the second diffusion step, the second well region is formed to extend to the first opening portion side exceeding a middle line between the first opening portion and the second opening portion along the lower surface of the substrate.

### BRIEF DESCRIPTION OF THE DRAWINGS

FIG. 1 is a top view of a semiconductor device according to Embodiment 1 of the present invention;
FIG. 2 is a cross-sectional view of the semiconductor device according to Embodiment 1 of the present invention;
FIG. 3 is an enlarged view of an element mounting surface of the semiconductor device according to Embodiment 1 of the present invention;
FIG. 4 is an enlarged view of a cross-sectional surface of a bonding region between a composite substrate and a fritted glass of the semiconductor device according to Embodiment 1 of the present invention;
FIG. 5 is an enlarged view of a cross-sectional surface of a diode structure unit of the semiconductor device according to Embodiment 1 of the present invention;
FIG. 6 is a drawing illustrating a manufacturing process of the semiconductor device according to Embodiment 1 of the present invention;
FIG. 7 is a drawing illustrating a manufacturing process of the semiconductor device according to Embodiment 1 of the present invention;
FIG. 8 is a drawing illustrating a manufacturing process of the semiconductor device according to Embodiment 1 of the present invention;
FIG. 9 is a cross-sectional view of the semiconductor device according to Embodiment 1 of the present invention in one step during the manufacture;
FIG. 10 is a cross-sectional view of the semiconductor device according to Embodiment 1 of the present invention in one step during the manufacture;
FIG. 11 is a cross-sectional view of the semiconductor device according to Embodiment 1 of the present invention in one step during the manufacture;
FIG. 12 is a cross-sectional view of the semiconductor device according to Embodiment 1 of the present invention in one step during the manufacture;
FIG. 13 is a cross-sectional view of the semiconductor device according to Embodiment 1 of the present invention in one step during the manufacture;
FIG. 14 is a cross-sectional view of the semiconductor device according to Embodiment 1 of the present invention in one step during the manufacture;
FIG. 15 is a cross-sectional view of the semiconductor device according to Embodiment 1 of the present invention in one step during the manufacture;
FIG. 16 is a cross-sectional view of the semiconductor device according to Embodiment 1 of the present invention in one step during the manufacture;
FIG. 17 is a cross-sectional view of the semiconductor device according to Embodiment 1 of the present invention in one step during the manufacture;
FIG. 18 is a cross-sectional view of the semiconductor device according to Embodiment 1 of the present invention in one step during the manufacture;
FIG. 19 is a cross-sectional view of the semiconductor device according to Embodiment 1 of the present invention in one step during the manufacture;
FIG. 20 is a cross-sectional view of the semiconductor device according to Embodiment 1 of the present invention in one step during the manufacture;
FIG. 21 is a cross-sectional view of the semiconductor device according to Embodiment 1 of the present invention in one step during the manufacture;
FIG. 22 is a cross-sectional view of the semiconductor device according to Embodiment 1 of the present invention in one step during the manufacture;
FIG. 23 is a cross-sectional view of the semiconductor device according to Embodiment 1 of the present invention in one step during the manufacture;
FIG. 24 is a cross-sectional view of the semiconductor device according to Embodiment 1 of the present invention in one step during the manufacture;
FIG. 25 is an enlarged view of a cross-sectional surface of a diode structure unit of the semiconductor device according to Embodiment 2 of the present invention;

### DETAILED DESCRIPTION OF THE INVENTION

The following describes embodiments of the present invention in detail. In the following description and attached drawings, the same reference numerals are attached to substantially same or equivalent portions. In the following description, a description of "material 1/material 2" means a stacked structure in which a material 2 is stacked on a material 1. A description of "material 1 material 2" means an alloy of the materials 1 and 2.

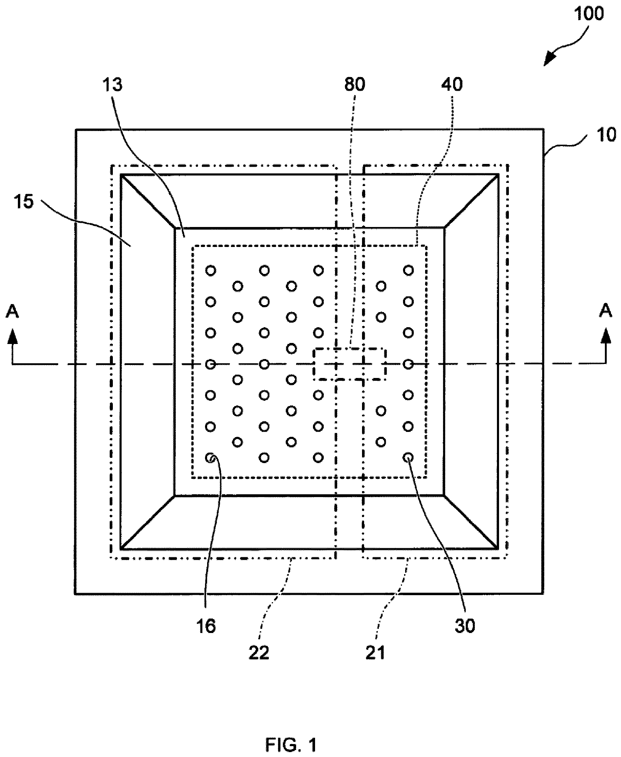

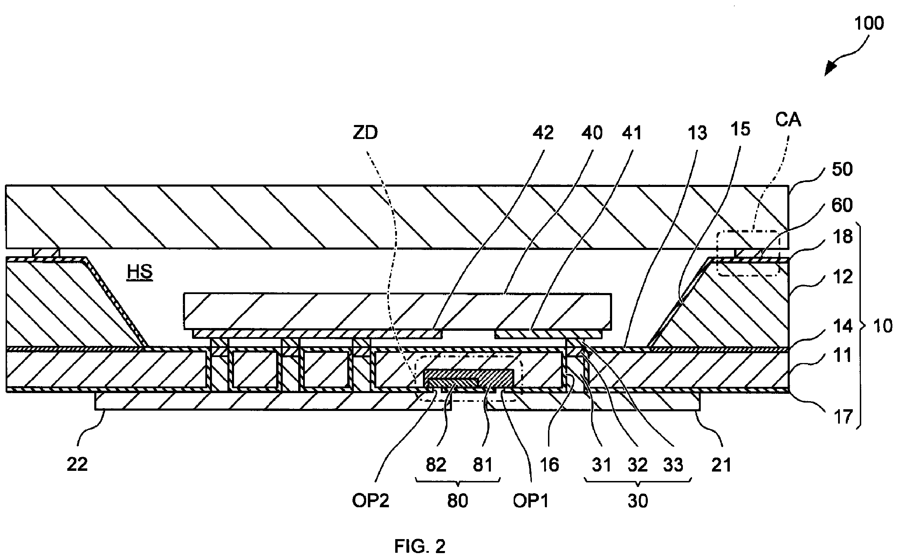

FIG. 1 is a top view of a semiconductor device 100 according to Embodiment 1. FIG. 2 is a cross-sectional view taken along a line A-A of the semiconductor device 100 of FIG. 1.

The semiconductor device 100 includes a composite substrate 10 having an upper surface provided with a cavity as a recessed portion, a semiconductor element 40 placed on an element mounting surface 13 as a cavity bottom surface of the composite substrate 10, and a lid member 50 formed above the upper surface of the composite substrate 10 to cover the cavity of the composite substrate 10. The semiconductor device 100 is provided with a plurality of through holes 16 penetrating from the bottom surface of the cavity to a lower surface of the composite substrate 10. The semiconductor device 100 includes a first external electrode 21 and a second external electrode 22, which are a pair of mounting electrodes, formed on a bottom surface of the composite substrate 10, and a plurality of through electrodes 30 that fill the plurality of through holes 16 of the composite substrate 10 and are electrically connected to the first external electrode 21 and the second external electrode 22. The semiconductor device 100 includes a diode structure unit 80 formed in a region along the lower surface of the composite substrate 10 inside the composite substrate 10. In FIG. 1, for clearly illustrating the structures and the positional relations of the respective components, the lid member 50 is omitted. In FIG. 1, for clearly illustrating the structures and the positional relations of the respective components, the semiconductor element 40 is illustrated by a dashed line.

As illustrated in FIG. 2, for example, the composite substrate 10 as a substrate is a Silicon On Insulator (SOI) substrate including a first substrate 11, a buried oxide film (BOX: Buried Oxide) 14, and a second substrate 12. The first substrate 11 has a principal surface of a crystal face of (100), is a first conductivity type, and is made of single-crystal silicon (Si). The buried oxide film 14 is formed on the upper surface of the first substrate 11 and is made of silicon oxide (SiO₂). The second substrate 12 has a principal surface of a crystal face of (100), is made of single-crystal silicon (Si), and is bonded to the upper surface of the first substrate 11 via the buried oxide film 14.

The first substrate 11 is, for example, an N-type semiconductor substrate of a first conductivity type in which Si is doped with N-type impurities, such as phosphorus (P) or arsenic (As). In the first substrate 11, for example, the N-type impurities are doped such that a carrier density becomes about 1E¹⁵ cm⁻³. The first substrate 11 is, for example, a flat plate-shaped semiconductor substrate having a thickness of about 50 µm.

The second substrate 12 is, for example, a substrate made of non-doped single crystal Si. The second substrate 12 is, for example, a substrate having a thickness of about 250 µm. The second substrate 12 is provided with an upper surface opening portion 15 opened to penetrate from an upper surface to a lower surface. In other words, the composite substrate 10 is provided with the upper surface opening portion 15 formed in the upper surface to penetrate from the upper surface of the second substrate 12 to the upper surface of the first substrate 11.

The upper surface opening portion 15 is formed, for example, so as to have an inner side surface of the upper surface opening portion 15 as a crystal face of (111) of the second substrate 12 in a manner in which the opening surface narrows from the upper surface toward the lower surface of the second substrate 12. Specifically, the inner side surface of the upper surface opening portion 15 is formed with an angle of about 54.74° with respect to the upper surface of the first substrate 11.

The composite substrate 10 is provided with the cavity formed by the first substrate 11 and the upper surface opening portion 15 of the second substrate 12. That is, the second substrate 12 functions as a sidewall portion of the cavity of the composite substrate 10. The upper surface of the first substrate 11 exposed from the upper surface opening portion 15 of the second substrate 12 is the bottom surface of the cavity and functions as the element mounting surface 13 on which the semiconductor element 40 is placed.

While a case where the second substrate 12 is a substrate made of non-doped single crystal Si is described in this embodiment, the second substrate 12 may be a semiconductor substrate having the conductivity type similar to the first substrate 11.

As described above, the semiconductor device 100 includes the composite substrate 10 that has N-type conductive property as the first conductivity type and is made of single-crystal silicon. The composite substrate 10 is formed by boding the plate-shaped first substrate 11 of the first conductivity type made of single-crystal silicon with the second substrate 12 that is disposed on the first substrate 11 and provided with the upper surface opening portion 15, which has the inner side surface forming the cavity as a recessed portion with the upper surface of the first substrate 11. On a surface in the second substrate 12 side of the first substrate 11, the buried oxide film 14 is formed.

The plurality of through holes 16 are formed in the lower surface of the composite substrate 10 so as to penetrate from the lower surface of the first substrate 11 to the element mounting surface 13 in columnar shapes. The plurality of through holes 16 are formed in a predetermined region in a region in the element mounting surface 13 as the bottom surface of the cavity in top view. Furthermore, the plurality of through holes 16 are regularly provided in the predetermined region.

A thermally-oxidized film 17 is formed on the element mounting surface 13, the lower surface, and the inner side surfaces of the plurality of through holes 16 of the first substrate 11 to cover the first substrate 11. A thermally-oxidized film 18 is formed on the upper surface and the inner side surface of the upper surface opening portion 15 of the second substrate 12 to cover the second substrate 12. In other words, in the composite substrate 10, the thermally-oxidized films 17 and 18 are formed on the upper surface and the lower surface.

The thermally-oxidized films 17 and 18 are, for example, oxidized films made of SiO₂ formed by performing a thermal oxidation treatment on the first substrate 11 and the second substrate 12, which are single crystal Si, respectively. Each of the thermally-oxidized films 17 and 18 is formed, for example, with a film thickness of about 0.5 µm. When the film thicknesses of the thermally-oxidized films 17 and 18 are small, especially on the upper surface of the second substrate 12, at a bonding portion with a fritted glass layer 60, which is a bonding layer with the lid member 50 described below, a failure, such as a crack, possibly occurs.

Similarly, the thermally-oxidized film 17 formed on the inner side surface of the through hole 16 is also formed with the film thickness of about 0.5 µm. This causes the thermally-oxidized films 17 and 18 to insulate the surface of the composite substrate 10. In other words, the composite substrate 10 is provided with the plurality of through holes 16 that penetrate from the bottom surface of the cavity to a back surface of the composite substrate 10 in columnar shapes and have the inner side surfaces covered with the thermally-oxidized film 17.

In this embodiment, the semiconductor device 100 has an aspect of a wafer level package (WLP: Wafer Level Package) in which a plurality of semiconductor devices 100 are collectively manufactured continuously in a grid pattern on a wafer-shaped composite substrate 10. The semiconductor devices 100 are formed in a matrix on the wafer so as to be continuously arranged in front to back and side to side directions. Then, the wafer is diced into individual pieces, thus manufacturing a plurality of semiconductor devices 100. Therefore, side surfaces of the first substrate 11 and the second substrate 12 as outer side surfaces of the semiconductor device 100 are cut surfaces of the dicing. Accordingly, on the respective outer side surfaces of the first substrate 11 and second substrate 12, the thermally-oxidized films 17 and 18 are not formed. While SiO₂ films are formed on the respective outer side surfaces of the first substrate 11 and the second substrate 12 by natural oxidation after the dicing step, the SiO₂ films by the natural oxidation are not illustrated in this description.

Each of the plurality of through electrodes 30 is formed in a columnar shape so as to fill the plurality of through holes 16 from the lower surface of the first substrate 11 and project from the element mounting surface 13 of the first substrate 11. The plurality of through electrodes 30 are formed by, for example, laminating a Cu layer 31, a Ni layer 32, and a AuSn layer 33 that is a metal bonding layer in this order from the lower surface of the first substrate 11. In other words, in the plurality of through holes 16, the plurality of columnar-shaped through electrodes 30 that fill the plurality of through holes 16 of the composite substrate 10 and project from the bottom surface of the cavity are formed.

The Cu layer 31 is, for example, filled inside each of the plurality of through holes 16 with a thickness of about 49 µm from the lower surface of the composite substrate 10. That is, the Cu layer 31 is formed to be filled up to a height lower than the element mounting surface 13 from the lower surface of the first substrate 11.

The Ni layer 32 is, for example, filled inside each of the plurality of through holes 16 with a thickness of about 1 µm on an upper surface of the Cu layer 31. That is, as illustrated in FIG. 2, the Ni layer 32 is formed such that an upper surface of the Ni layer 32 becomes same as an upper surface of the element mounting surface 13 in height.

The AuSn layer 33 is formed on the upper surface of the Ni layer 32 with a thickness of about 5 µm so as to project with respect to the upper surface of the element mounting surface 13. That is, as illustrated in FIG. 2, the AuSn layer 33 is formed to have an upper surface shape along an upper surface shape of the Ni layer 32.

The AuSn layer 33 is melted by a heating treatment, and functions as a metal bonding layer bonded to an anode electrode 42 or a cathode electrode 41 formed on a bottom surface of the semiconductor element 40 described below by eutectic bonding. The Ni layer 32 functions as a barrier layer that suppresses diffusion and mixing of the Cu layer 31 and the AuSn layer 33.

The Ni layers 32 of the plurality of through electrodes 30 preferably have height positions of their upper surfaces at positions same as or lower than the element mounting surface 13 of the first substrate 11 for ensuring bonding stability with the semiconductor element 40 described below. In a case where the Ni layer 32 is at a position higher than the element mounting surface 13, when the semiconductor element 40 described below is bonded, for example, an electrode of the semiconductor element 40 possibly contacts the Ni layer 32, thus possibly affecting the bonding stability of the semiconductor element 40.

The plurality of through electrodes 30 are formed at the plurality of respective through holes 16 regularly provided in the element mounting surface 13, and each of the plurality of through electrodes 30 is bonded to the cathode electrode 41 or the anode electrode 42 of the semiconductor element 40. This allows avoiding generation of voids between the cathode electrode 41 and the anode electrode 42 of the semiconductor element 40 and the plurality of respective through electrodes 30. Specifically, when the cathode electrode 41 and the anode electrode 42 of the semiconductor element 40 are bonded to internal electrodes having upper surface shapes approximately similar thereto by surface bonding, air bubbles are trapped in melted AuSn, and voids are possibly generated at unintended random positions.

Each of the first external electrode 21 and the second external electrode 22 is, for example, an electrode including metal layers of titanium (Ti)/copper (Cu)/Nickel (Ni)/gold (Au) laminated in this order from the thermally-oxidized film 17 side of the composite substrate 10. The first external electrode 21 and the second external electrode 22 are formed to be mutually spaced and cover the plurality of respective through electrodes 30 formed in the lower surface of the composite substrate 10. The first external electrode 21 and the second external electrode 22 are electrically in contact with the plurality of through electrodes 30 at the lower surface of the composite substrate 10. That is, in the semiconductor device 100, the lower surface side is a mounting surface to a mounting substrate (not illustrated), and the first external electrode 21 and the second external electrode 22 function as mounting electrodes to the mounting substrate.

The plurality of through electrodes 30 are formed to fill the plurality of respective through holes 16. The first external electrode 21 and the second external electrode 22 are formed to cover the plurality of respective through electrodes 30 at the lower surface of the composite substrate 10. In other words, the plurality of through electrodes 30 electrically connect the pair of electrodes of the semiconductor element 40 to the respective first external electrode 21 and second external electrode 22.

Accordingly, the inside of the cavity of the composite substrate 10 is airtight to the lower surface side of the composite substrate 10 via the plurality of through holes 16.

The semiconductor element 40 is placed on the upper surface of the element mounting surface 13. In this embodiment, the semiconductor element 40 is, for example, a light-emitting element that includes an aluminum gallium nitride (AlGaN) based semiconductor layer as a light-emitting layer and emits a deep ultraviolet light. Specifically, the semiconductor element 40 is a semiconductor element in which an N-type AlGaN semiconductor layer, an AlGaN active layer, and a P-type AlGaN semiconductor layer are laminated on an aluminum nitride (AlN) substrate, and a deep ultraviolet light is emitted from the AlGaN active layer. In this embodiment, the AlN substrate, the N-type AlGaN semiconductor layer, the AlGaN active layer, and the P-type AlGaN semiconductor layer are formed from the upper surface side of the semiconductor element 40. In other words, the semiconductor device 100 includes the semiconductor element 40 that is disposed on the composite substrate 10 and includes the semiconductor layer. The semiconductor element 40 is a light-emitting element that emits an ultraviolet light from the semiconductor layer.

The semiconductor element 40 includes the cathode electrode 41 and the anode electrode 42 formed on the lower surface of the semiconductor element 40. The cathode electrode 41 is electrically connected to the N-type AlGaN semiconductor layer, and is made of a metal. The anode electrode 42 is electrically connected to the P-type AlGaN semiconductor layer, and is made of a metal.

The cathode electrode 41 and the anode electrode 42 have exposed surfaces coated with metal layers made of Au. That is, the semiconductor element 40 is a semiconductor element of an aspect of flip chip connection in which a pair of electrodes of the cathode electrode 41 and the anode electrode 42 are formed on the lower surface. That is, the semiconductor element 40 includes a pair of electrodes of the cathode electrode 41 and the anode electrode 42 on the lower surface.

Accordingly, in the semiconductor element 40, a deep ultraviolet light emitted from the AlGaN active layer passes through the AlN substrate, and is emitted from the upper surface of the semiconductor element 40. That is, the upper surface of the AlN substrate as the upper surface of the semiconductor element 40 functions as a light extraction surface of the semiconductor element 40, and the lower surface on which the cathode electrode 41 and the anode electrode 42 are formed functions as a mounting surface to the composite substrate 10.

In the semiconductor element 40, each of the cathode electrode 41 and the anode electrode 42 is bonded to be placed over the upper surfaces of the plurality of respective through electrodes 30. Specifically, the cathode electrode 41 and the anode electrode 42 of the semiconductor elements 40 are bonded to the AuSn layers 33 of the respective through electrodes 30. In the semiconductor element 40, as illustrated in FIG. 2, the cathode electrode 41 is electrically connected to the first external electrode 21 via the through electrode 30, and the anode electrode 42 is electrically connected to the second external electrode 22 via the through electrode 30. That is, in the semiconductor device 100, the first external electrode 21 functions as a cathode mounting electrode (negative electrode), and the second external electrode 22 functions as an anode mounting electrode (positive electrode).

In this embodiment, the semiconductor element 40 is a light-emitting element that emits an ultraviolet light from the AlGaN active layer. The semiconductor element 40 is driven by applying a voltage value of 6 V or more in a direction from the anode electrode 42 to the cathode electrode 41 (forward electric potential).

The lid member 50 is disposed on the upper surface of the composite substrate 10 to cover the cavity of the composite substrate 10. The lid member 50 is, for example, a deep ultraviolet transmissive glass that contains SiO₂ as a main raw material and transmits a deep ultraviolet emitted from the semiconductor element 40. The lid member 50 has a thermal expansion coefficient of, for example, 3×10⁻⁶/°C or more and 5×10⁻⁶/°C or less, and is formed to be matched with a thermal expansion coefficient (3.9×10⁻⁶/°C) of the first substrate 11 and the second substrate 12 that are single crystal Si.

The lid member 50 is bonded to the upper surface of the composite substrate 10 via the fritted glass layer 60. In other words, the semiconductor device 100 further includes the lid member 50 that is bonded to the upper surface of the composite substrate 10 via the fritted glass layer 60 and is made of a glass.

The fritted glass layer 60 is, for example, a glassy bonding layer using a paste containing powdery fritted glass as a raw material. In the fritted glass layer 60, the paste as a raw material is preliminarily applied over a surface opposed to the upper surface of the second substrate 12 of the lid member 50 so as to surround a periphery of the cavity of the composite substrate 10. The lid member 50 over which the paste has been applied is calcined at about 500°C before bonding to the composite substrate 10.

The fritted glass layer 60 is, for example, a glass containing SiO₂ as a main raw material. The fritted glass layer 60 joins the lid member 50 to the second substrate 12 by heating and melting the fritted glass layer 60 surrounding the periphery of the cavity of the composite substrate 10. The fritted glass layer 60 is melted by being locally heated in a short time with a laser described later, thereby bonding the lid member 50 to the second substrate 12.

With the lid member 50 bonded to the upper surface of the second substrate 12 via the fritted glass layer 60, the inside of the cavity of the composite substrate 10 is airtight to the upper surface side of the composite substrate 10 via the lid member 50 and the fritted glass layer 60. That is, the semiconductor device 100 is provided with a housing space HS in which the inside of the cavity formed by the first substrate 11 and the second substrate 12 is sealed to be airtight. In the housing space HS, for example, a sealing gas, such as a nitrogen (N₂) gas, not degenerated by an ultraviolet light is filled.

For the lid member 50 and the fritted glass layer 60, similarly to the composite substrate 10, the fritted glass layers 60 are continuously formed in a grid pattern on a surface opposed to the composite substrate 10 of a wafer-shaped lid member 50. That is, the lid member 50 is bonded via the fritted glass layer 60 so as to collectively cover a plurality of cavities formed in a grid pattern on the composite substrate 10 in the manufacture of the semiconductor device 100. The lid member 50 is cut simultaneously with the composite substrate 10 in a dicing step during the manufacture. Accordingly, using a wafer-shaped composite substrate 10 for the composite substrate 10 allows manufacturing the semiconductor device 100 as a wafer level package (WLP: Wafer Level Package) in which the semiconductor devices 100 are formed in a grid pattern on the wafer.

Conventionally, there has been a drawback in a tact or a cost in the manufacture because individual substrates made of AlN are used and it is necessary to airtightly seal the substrates one by one. In this embodiment, for the semiconductor device 100, it is allowed that cavities are formed in a grid pattern on a wafer-shaped composite substrate 10, and collectively airtightly sealed with the lid member 50 on which the fritted glass layer 60 has been formed, and then diced into individual pieces. Accordingly, in the semiconductor device 100, the tact or the cost in the manufacture can be improved.

Conventionally, the AlN substrate and the lid member are airtightly sealed using the eutectic bonding by AuSn. Therefore, in the semiconductor device, the eutectic bonding by AuSn is performed twice, bonding of the semiconductor element to the element mounting portion and bonding of the lid member to the AlN substrate. In this respect, in the second AuSn eutectic bonding, which is the bonding of the lid member, as the airtight sealing, AuSn used for bonding the semiconductor element is remelted, thereby possibly causing a manufacturing failure, such as a displacement of mounting position of the semiconductor element.

In this embodiment, in the semiconductor device 100, the part at which the eutectic bonding by AuSn is performed in the manufacture is only the bonding of the semiconductor element 40, and the lid member 50 is heated locally in a short time with a laser to the fritted glass layer 60. This allows avoiding remelting of the eutectic bonding layers by AuSn between the semiconductor element 40 and the plurality of respective through electrodes 30 during the bonding of the lid member 50 to the composite substrate 10. Accordingly, in the semiconductor device 100, a manufacturing failure, such as a displacement of mounting position of the semiconductor element, caused by the remelting of AuSn during the manufacture can be avoided.

The diode structure unit 80 is formed in a region along the lower surface inside the first substrate 11 to be spaced from the plurality of through holes 16. The diode structure unit 80 includes, for example, a P-type well region 81 as a first well region of a second conductivity type in a first region over the first external electrode 21 and the second external electrode 22 on the lower surface of the first substrate 11. In the P-type well region 81, P-type impurities, such as boron (B), are diffused from the lower surface side of the first substrate 11. The diode structure unit 80 includes, for example, an N⁺-type well region 82 as a second well region of a first conductivity type in a second region in the first region on the lower surface of the first substrate 11. In the N⁺-type well region 82, N-type impurities, such as phosphorus (P), are diffused from the lower surface side of the first substrate 11.

The thermally-oxidized film 17 formed on a lower surface of the P-type well region 81 is provided with a first opening portion OP1 opened to penetrate to the lower surface of the P-type well region 81. The first opening portion OP1 is formed to be filled with the first external electrode 21. That is, at the first opening portion OP1, the P-type well region 81 is electrically in contact with the first external electrode 21.

The thermally-oxidized film 17 formed on a lower surface of the N⁺-type well region 82 is provided with a second opening portion OP2 opened to penetrate to the lower surface of the N⁺-type well region 82. The second opening portion OP2 is formed to be filled with the second external electrode 22. That is, at the second opening portion OP2, the N⁺-type well region 82 is electrically in contact with the second external electrode 22. In other words, the semiconductor device 100 includes the diode structure unit 80 that is provided with the first opening portion OP1 and the second opening portion OP2 and includes the P-type well region 81 and the N⁺-type well region 82. The first opening portion OP1 and the second opening portion OP2 are mutually spaced in the thermally-oxidized film 17 formed on the lower surface of the composite substrate 10. The P-type well region 81 is formed in a first region along the lower surface of the composite substrate 10, and exposed at the first opening portion OP1. The P-type well region 81 is a first well region having a second conductivity type different from a first conductivity type. The N⁺-type well region 82 is formed in a second region along a lower surface in the first region, and exposed at the second opening portion OP2. The N⁺-type well region 82 is a second well region having the first conductivity type.

Therefore, the diode structure unit 80 is a pn junction diode including the P-type well region 81 and the N⁺-type well region 82 disposed between the first external electrode 21 and the second external electrode 22 inside the first substrate 11 as the N-type semiconductor substrate.

The first external electrode 21 is connected to the cathode electrode 41 of the semiconductor element 40 and the P-type well region 81 as an anode of the diode structure unit 80. The second external electrode 22 is connected to the anode electrode 42 of the semiconductor element 40 and the N⁺-type well region 82 as a cathode of the diode structure unit 80. That is, the diode structure unit 80 functions as a zener diode connected to the semiconductor element 40 in parallel with reversed polarity between the first external electrode 21 and the second external electrode 22. In other words, the semiconductor device 100 includes the first external electrode 21 that is disposed on the lower surface of the thermally-oxidized film 17 and in contact with the P-type well region 81 at the first opening portion OP1, and the second external electrode 22 that is disposed on the lower surface of the thermally-oxidized film 17, spaced from the first external electrode 21, and in contact with the N⁺-type well region 82 at the second opening portion OP2.

In the P-type well region 81, boron as a P-type impurity is diffused from the lower surface side of the first substrate 11 so as to have a carrier density of about 1E¹⁷ cm⁻³. In the N⁺-type well region 82, phosphorus as an N-type impurity is diffused from the lower surface side of the first substrate 11 so as to have a carrier density of about 1E¹⁹ cm⁻³. That is, the diode structure unit 80 is a zener diode having a structure of one-sided abrupt junction in which the carrier density is higher in the N⁺-type well region 82 than in the P-type well region 81.

The diode structure unit 80 operates to protect the semiconductor element 40, for example, when an overvoltage, such as a static electricity, is applied to the semiconductor element 40 from outside. Specifically, when an overvoltage due to a static electricity is applied in a direction from the second external electrode 22 to the first external electrode 21 (forward electric potential), the diode structure unit 80 flows a current in a direction from the N⁺-type well region 82 as the cathode to the P-type well region 81 as the anode. This allows the diode structure unit 80 to keep the electric potential of the semiconductor element 40 constant and protect the semiconductor element 40.

The semiconductor element 40 is, as described above, a semiconductor element driven by applying a voltage value of 6 V or more to the anode electrode 42 and the cathode electrode 41. That is, the diode structure unit 80 having the structure of one-sided abrupt junction is a zener diode in which an electron avalanche breakdown (avalanche breakdown) dominantly acts when the overvoltage is applied. That is, the diode structure unit 80 is a zener diode or an avalanche diode.

Thus, in this embodiment, a zener diode is disposed inside the composite substrate 10 of the semiconductor device 100 as the diode structure unit 80. This allows including the semiconductor element 40 and the diode structure unit 80 as a zener diode without placing the semiconductor element 40 and the zener diode that is an individual semiconductor side by side in the cavity as a recessed portion of the composite substrate 10. Accordingly, the area of the cavity bottom surface of the composite substrate 10 can be decreased, and the outer shape of the semiconductor device 100 can be reduced as well. According to a validation by the inventors, in the semiconductor device 100 of this embodiment, a mounting area (lower surface area) of the semiconductor device 100 can be reduced by about 50% compared with a semiconductor device having a structure in which the zener diode as an individual semiconductor and the semiconductor element 40 are placed side by side in the cavity.

In this embodiment, the semiconductor element 40 is a light-emitting element that emits an ultraviolet light from the semiconductor layer. By disposing the zener diode inside the composite substrate 10 of the semiconductor device 100 as the diode structure unit 80, the semiconductor element 40 can be placed in the center of the cavity. Accordingly, the light emitted from the semiconductor element 40 is uniformly irradiated on the inner side surface of the upper surface opening portion 15, thus allowing suppressing luminance unevenness of the light output from the semiconductor device 100 and deviation of light emitting direction. Additionally, compared with the case where the semiconductor element 40 and the zener diode as an individual semiconductor are placed side by side in the cavity, the light extraction efficiency of the semiconductor device 100 can be improved because the light emitted from the semiconductor element 40 is not blocked or absorbed by the zener diode as an individual semiconductor. According to a validation by the inventors, in the semiconductor device 100 of this embodiment, an optical output of the semiconductor device 100 can be improved by about 14% compared with a semiconductor device having a structure in which the zener diode as an individual semiconductor and the semiconductor element 40 are placed side by side in the cavity.

In this embodiment, the semiconductor device 100 has an aspect of a wafer level package (WLP: Wafer Level Package) in which a plurality of semiconductor devices 100 are collectively manufactured continuously in a grid pattern on a wafer-shaped composite substrate 10. That is, the diode structure units 80 are collectively disposed on the lower surfaces in the manufacture regions of the respective semiconductor devices 100 of the wafer-shaped composite substrate 10. Accordingly, in the semiconductor device 100 of this embodiment, compared with a semiconductor device having a structure in which the zener diode as an individual semiconductor and the semiconductor element 40 are placed side by side in the cavity, a dicing step, a die bonding step, or the like of the zener diode as an individual semiconductor can be omitted. Accordingly, in the semiconductor device 100 of this embodiment, the productivity can be improved, and the manufacturing cost can be reduced.

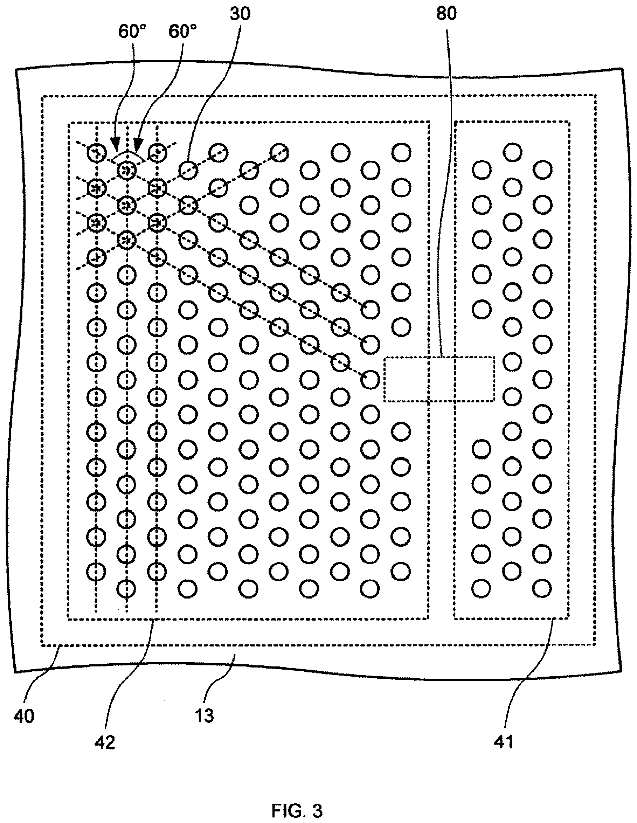

FIG. 3 is an enlarged view of the upper surface of the element mounting surface 13 illustrating a structure of the plurality of through electrodes 30 of the semiconductor device 100 according to Embodiment 1. In FIG. 3, for clearly illustrating the structure and the positional relation of the plurality of through electrodes 30, the semiconductor element 40, the cathode electrode 41, the anode electrode 42, and the diode structure unit 80 are illustrated by dashed lines.

As illustrated in FIG. 3, the plurality of respective through electrodes 30 are disposed in the regions in which the cathode electrode 41 and the anode electrode 42 of the semiconductor element 40 are placed. The plurality of through electrodes 30 are disposed to be each spaced from the region in which the diode structure unit 80 is disposed. That is, the plurality of through electrodes 30 are insulated from the diode structure unit 80 by the thermally-oxidized film 17 formed on the inner side surfaces of the plurality of through holes 16.

Each of the plurality of through electrodes 30 is, for example, formed in a columnar shape having a diameter of 30 µm. In the semiconductor element 40, a plurality of through electrodes 30 are bonded to each of one electrode surfaces of the cathode electrode 41 and the anode electrode 42.

When an internal electrode having a shape similar to the cathode electrode 41 and the anode electrode 42 of the semiconductor element 40 is formed on the element mounting surface 13, AuSn bonding is made between the internal electrode and the cathode electrode 41 or the anode electrode 42 at one surfaces thereof. In this case, in the bonding surface between the internal electrode and the cathode electrode 41 or the anode electrode 42, a void that cannot be predicted or cannot be controlled is possibly generated inside the AuSn bonding layer. This void possibly affects the reliability, for example, a crack of the bonding layer at heat generation in driving of the manufactured semiconductor element.

In this embodiment, the plurality of through electrodes 30 are formed to be mutually spaced. The semiconductor element 40 is bonded to be placed over the upper surfaces of the plurality of respective through electrodes 30. This allows suppressing occurrence of a void that cannot be predicted or cannot be controlled in bonding interfaces between the semiconductor element 40 and the plurality of through electrodes 30, thus allowing reduction of the influence on the reliability by the void of the respective bonding portions between the semiconductor element 40 and the plurality of through electrodes 30 after the manufacture of the semiconductor device 100.

As illustrated in FIG. 3, the plurality of through electrodes 30 are located on respective lattice points in an equilateral triangular grid on the bottom surface of the cavity. The plurality of through electrodes 30 are each formed in a column having a diameter of 30 µm, and are arranged such that a distance between center points of the adjacent through electrodes 30 becomes 60 µm. By disposing the plurality of through electrodes 30 in the arrangement as described above, each of the plurality of through electrodes 30 is located such that distances between one through electrode 30 and other through electrodes 30 disposed therearound become uniform.

When the plurality of through electrodes 30 are disposed on lattice points of a square grid in a matrix, separation distances between one through electrode 30 and other through electrodes 30 disposed at upper, lower, right, and left sides are the same distance in top view. However, a distance between the one through electrode 30 and another through electrode 30 disposed in an oblique direction is different. Therefore, at heat generation or the like in the bonding of the semiconductor element 40, the driving of the semiconductor element 40, or the like, a stress is unevenly applied in the plane of the upper surface of the element mounting surface 13, and a minute crack or the like is possibly generated in the first substrate 11 to break the airtightness inside the cavity.

In this embodiment, as described above, the plurality of through electrodes 30 are located on the respective lattice points of the equilateral triangular grid. Accordingly, since a stress is uniformly applied in the plane of the upper surface of the element mounting surface 13 at heat generation or the like in the bonding of the semiconductor element 40 or the driving of the semiconductor element 40, the crack or the like of the first substrate 11 can be suppressed.

Additionally, as described in this embodiment, by disposing the plurality of through electrodes 30 on the respective lattice points of the equilateral triangular grid, for the plurality of through electrodes 30, the larger number of the plurality of through electrodes 30 can be disposed compared with a plurality of through electrodes 30 disposed in a matrix. This allows more releasing the heat generated in the driving of the semiconductor element 40 to the mounting substrate. According to a validation by the inventors, by disposing the plurality of through electrodes 30 at the respective lattice points of the equilateral triangular grid as described in this embodiment, the plurality of through electrodes 30 can be disposed 1.2 times larger in number compared with a plurality of through electrodes 30 disposed in a matrix.

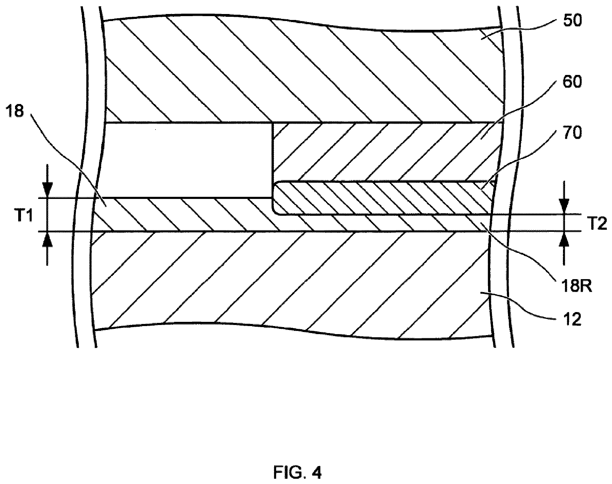

FIG. 4 is an enlarged view of a bonding portion CA between the fritted glass layer 60 and the second substrate 12 illustrated in FIG. 2.

As described above, the composite substrate 10 is bonded to the lid member 50 via the fritted glass layer 60. On the upper surface of the second substrate 12, the thermally-oxidized film 18 is formed. At this time, between the fritted glass layer 60 and the second substrate 12, an interdiffusion layer 70 as a reaction layer, in which the fritted glass layer 60 and the thermally-oxidized film 18 are mutually diffused, and a remaining thermally-oxidized film 18R are formed in this order from above. In other words, in the bonding portion between the composite substrate 10 and the fritted glass layer 60, the remaining thermally-oxidized film 18R of the thermally-oxidized film 18 and the interdiffusion layer 70 as a reaction layer of the thermally-oxidized film 18 and the fritted glass layer 60 are formed in this order from the surface of the composite substrate 10 between the composite substrate 10 and the fritted glass layer 60.

The interdiffusion layer 70 is formed by interdiffusion of SiO₂ of the thermally-oxidized film 18 formed on the upper surface of the second substrate 12 and SiO₂ of the fritted glass layer 60 caused by heating and melting the fritted glass layer 60. That is, the bonding portion of the fritted glass layer 60 has a structure in which the remaining thermally-oxidized film 18R, the interdiffusion layer 70, and the fritted glass layer 60 are laminated in this order from the upper surface of the second substrate 12. The thermally-oxidized film 18 is formed with a film thickness (T1) of the thermally-oxidized film 18 of about 0.5 µm in a thermal oxidation treatment.

A film thickness (T2) of the remaining thermally-oxidized film 18R is preferably remained with a film thickness of 0.5 times or more of the film thickness (T1) of the thermally-oxidized film 18. That is, the film thickness (T2) of the remaining thermally-oxidized film 18R is preferably remained with a film thickness of 0.25 µm or more. For the remaining thermally-oxidized film 18R, the film thickness of the thermally-oxidized film 18 of about 0.5 µm can ensure remaining of the remaining thermally-oxidized film 18R after the thermal treatment.

When the film thickness (T2) of the remaining thermally-oxidized film 18R is thin, or when the remaining thermally-oxidized film 18R is not formed, a crack is possibly generated near the lower end of the interdiffusion layer 70, thus breaking the airtight sealing of the housing space HS.

The thermally-oxidized film 18 is formed as a SiO₂ film by diffusion of oxygen from the surface of the second substrate 12 that is single crystal Si caused by the thermal oxidation treatment. Therefore, the thermally-oxidized film 18 is not evenly formed as perfect SiO₂ from the upper surface of the thermally-oxidized film 18 to the upper surface of the second substrate 12, and becomes close to a crystalline nature of single crystal Si while an amount of oxygen loss of SiO₂ increases toward the lower side from the thermally-oxidized film 18. In other words, an abundance ratio of SiO₂ to Si increases and the Si crystalline nature is lost from the upper surface of the second substrate 12 toward the upper side. That is, in the thermally-oxidized film 18 near the surface of the second substrate 12, the Si crystalline nature is partially provided, and Si and SiO₂ are mixed.

The interdiffusion layer 70 of the thermally-oxidized film 18 and the fritted glass layer 60 is SiO₂ of an amorphous structure. That is, when the film thickness (T2) of the remaining thermally-oxidized film 18R is thin, the upper end of the remaining thermally-oxidized film 18R is possibly provided with Si and a part of its crystalline nature.

When a SiO₂ layer having an amorphous structure is bonded to a SiO₂ layer provided with Si and a part of its crystalline nature, an array of atoms rapidly changes at the bonding interface. In this case, a bonding strength of the bonding interface is expected to be low. Therefore, when a stress is applied to the bonding interface due to heat generation or the like at the driving of the semiconductor element 40, a crack is possibly generated in the bonding interface, and the airtight sealing of the housing space HS is possibly broken. In contrast, when sufficiently amorphous-structured SiO₂ layers are mutually bonded, since both are not provided with the crystalline nature, the rapid change of the array of atoms does not occur, and therefore, the stress is less likely to be generated in heat generation or the like. That is, the remaining thermally-oxidized film 18R functions as a buffer layer that reduces a lattice mismatch between the second substrate 12 and the interdiffusion layer 70.

Accordingly, when the remaining thermally-oxidized film 18R remains with the film thickness of 0.25 µm or more estimated as a film thickness at least with which sufficiently amorphous-structured SiO₂ is obtained, the composite substrate 10 can be bonded to the lid member 50 via the fritted glass layer 60 with the high bonding strength.

That is, the remaining thermally-oxidized film 18R functions as a buffer layer that reduces an internal stress caused by a difference of crystalline structure between the second substrate 12 that is single-crystal silicon and the fritted glass layer 60 that is SiO₂ having an amorphous structure. Note that it is only necessary the film thickness (T2) of the remaining thermally-oxidized film 18R is a film thickness at least with which the sufficiently amorphous-structured SiO₂ is obtained.

As described above, in the bonding portion between the fritted glass layer 60 and the second substrate 12, layers are formed in the order of the remaining thermally-oxidized film 18R, the interdiffusion layer 70, and the fritted glass layer 60 from the upper surface of the second substrate 12, and this allows holding the high airtightness of the housing space HS. According to a validation by the inventors, the housing space HS of the semiconductor device 100 was able to obtain the airtightness equal to or more than those of an AlN substrate that is a conventional product and a product in which an AlN substrate is bonded to a lid member by AuSn in a helium (He) leak testing specified by Japanese Industrial Standard JIS-Z2331.

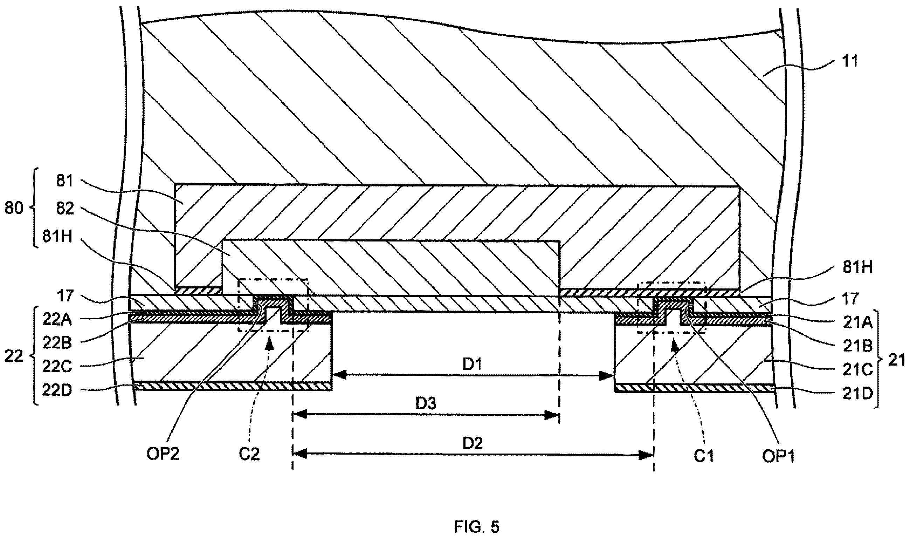

FIG. 5 is an enlarged view of a ZD part illustrating the diode structure unit 80 illustrated in FIG. 2.

As described above, the diode structure unit 80 is disposed in the region along the lower surface in the first substrate 11. On the lower surface of the first substrate 11, the thermally-oxidized film 17 formed by wet thermal oxidation treatment is disposed. On the lower surface of the thermally-oxidized film 17, a pair of external electrodes, the first external electrode 21 and the second external electrode 22, formed to be mutually spaced are disposed.

The diode structure unit 80 includes the P-type well region 81 formed in the region over the first external electrode 21 and the second external electrode 22 and the N⁺-type well region 82 formed in the P-type well region 81 on the lower surface of the first substrate 11.

The P-type well region 81 includes a P⁺ segregation layer 81H, which is a high concentration well region in which boron as an impurity is segregated in the region, in a region along the lower surface of the first substrate 11. The P⁺ segregation layer 81H is formed to have a thickness of, for example, about several nm to ten and several nm from the lower surface of the first substrate 11. In the P⁺ segregation layer 81H, for example, boron as an impurity is segregated to have a carrier density of about 1E¹⁹ cm⁻³. In other words, the P-type well region 81 includes the P⁺ segregation layer 81H having the higher carrier density in one region facing the first opening portion OP1 than in the other region.

The thermally-oxidized film 17 formed on the lower surface of the first substrate 11 is provided with the first opening portion OP1 opened such that a part of a region in which the P-type well region 81 overlaps with the first external electrode 21 penetrates from the lower surface of the thermally-oxidized film 17 to the lower surface of the P-type well region 81. The thermally-oxidized film 17 is provided with the second opening portion OP2 formed by removing a part of a region in which the N⁺-type well region 82 overlaps with the second external electrode 22 so as to penetrate from the lower surface of the thermally-oxidized film 17 to the lower surface of the N⁺-type well region 82. That is, the P⁺ segregation layer 81H of the P-type well region 81 has a lower surface exposed at the first opening portion OP1, and the N⁺-type well region 82 has a lower surface exposed at the second opening portion OP2.

The first external electrode 21 is disposed in the region including the first opening portion OP1 on the lower surface of the thermally-oxidized film 17. The second external electrode 22 is disposed in the region including the second opening portion OP2 on the lower surface of the thermally-oxidized film 17. The first external electrode 21 and the second external electrode 22 are formed by laminating Ti seed layers 21A and 22A made of titanium (Ti), Cu seed layers 21B and 22B made of copper (Cu), Ni plated layers 21C and 22C made of nickel (Ni), and AuSn plated layers 21D and 22D made of gold-tin (AuSn) alloy in this order from the lower surface side of the thermally-oxidized film 17. At the first opening portion OP1 and the second opening portion OP2, the Ti seed layers 21A and 22A are formed to cover the exposed surface of the lower surface of the P⁺ segregation layer 81H and the exposed surface of the lower surface of the N⁺-type well region 82.

That is, the first external electrode 21 forms a first contact portion C1 in which the Ti seed layer 21A is electrically in contact with the P⁺ segregation layer 81H at the first opening portion OP1. The second external electrode 22 forms a first contact portion C2 in which the Ti seed layer 22A is electrically in contact with the N⁺-type well region 82 at the second opening portion OP2. In other words, in the first external electrode 21 and the second external electrode 22, the Ti seed layers 21A and 22A, the Cu seed layers 21B and 22B, and the Ni plated layers 21C and 22C are laminated in this order from the lower surface of the composite substrate 10 at the first opening portion OP1 and the second opening portion OP2, respectively.

Usually, when a P-type semiconductor, especially a P-type semiconductor having the carrier density of about 1E¹⁷ cm⁻³ is bonded to a metal layer of Ti or the like so as to obtain an ohmic contact, the P-type semiconductor and the metal layer are alloyed at the bonding interface by performing a heating treatment, a laser irradiation treatment, or the like, thus causing the ohmic contact.

In this embodiment, in the P-type well region 81, the P⁺ segregation layer 81H having the carrier density of about 1E¹⁹ cm⁻³ is formed with the thickness of about several nm to ten and several nm in the contact region of the P-type well region 81 and the Ti seed layer 21A. This allows reduction of a width of a depletion layer between the P⁺ segregation layer 81H and the Ti seed layer 21A, and a tunneling effect is caused in the depletion layer between the P⁺ segregation layer 81H and the Ti seed layer 21A, thereby allowing the achievement of the ohmic contact.

Specifically, boron contained in the P-type well region 81 as an impurity has a segregation coefficient of 0.8 inside a single-crystal silicon, and falls into the category of large among the impurities used for semiconductors. Therefore, the boron contained in the P-type well region 81 is segregated near the interface of the thermally-oxidized film 17 in a thermally-oxidized film formation step in which wet thermal oxidation (about 950°C) is performed multiple times in a manufacturing method described below, thus forming the P⁺ segregation layer 81H. Accordingly, in the first contact portion C1, the P⁺ segregation layer 81H having the high carrier density is bonded to the Ti seed layer 21A, thus allowing the achievement of the ohmic contact.

According to the inventors, it was confirmed that when a reverse voltage (voltage in a direction from the second external electrode 22 to the first external electrode 21) of 7 V was applied to the diode structure unit 80 of this embodiment, a leak current flowed to the diode structure unit 80 was a small leak current of 94 nA. That is, it was indicated that the diode structure unit 80 provided a satisfactory PN junction between the P-type well region 81 and the N⁺-type well region 82, and provided satisfactory ohmic contacts at the first contact portion C1 and the second contact portion C2.

Note that the carrier density of the N⁺-type well region 82 is about 1E¹⁹ cm⁻³, and this allows the achievement of the ohmic contact with the Ti seed layer 21A.

In the operation of the diode structure unit 80, the carrier moves between the P-type well region 81 electrically in contact with the first external electrode 21 and the N⁺-type well region 82 electrically in contact with the second external electrode 22. In the bonding interface between the P-type well region 81 and the first substrate 11 that is an N-type semiconductor substrate, a depletion layer due to an internal electric field is formed. That is, the first substrate 11 is substantially insulated from the P-type well region 81, and in an electrically floating state. This allows the semiconductor device 100 to suppress a leak current from the side surface of the first substrate 11 to another adjacent semiconductor device on the mounting substrate when an overvoltage is applied on the mounting substrate.

An inter-electrode distance D1 between a pair of mounting electrodes, the first external electrode 21 and the second external electrode 22, is, for example, about 0.5 mm. The first contact portion C1 and the second contact portion C2 are formed to be positioned at the inner sides of the first external electrode 21 and the second external electrode 22 with respect to mutually opposed sides of the first external electrode 21 and the second external electrode 22, respectively. A distance D2 between the first contact portion C1 and the second contact portion C2 is, for example, 0.7 mm.

Between the electrodes of the first external electrode 21 and the second external electrode 22, the diode structure unit 80 is covered with the thermally-oxidized film 17. That is, the diode structure unit 80 is insulated by the thermally-oxidized film 17 in the region excluding the first contact portion C1 and the second contact portion C2. Accordingly, in the mounting to the mounting substrate, the semiconductor device 100 can suppress the leak current to the diode structure unit 80 even when the first external electrode 21 and the second external electrode 22 are bonded using a molten metal of AuSn, a solder, or the like.

As described above, the semiconductor element 40 is a light-emitting element driven by applying a voltage value of 6 V or more. Therefore, the diode structure unit 80 preferably has a breakdown voltage having a voltage value of double or more in an opposite direction of a voltage application direction of a driving voltage of the semiconductor element 40.

In this embodiment, the diode structure unit 80 is a zener diode having a structure of one-sided abrupt junction including the P-type well region 81 and the N⁺-type well region 82 with the carrier density higher than that of the P-type well region 81. The diode structure unit 80 having the structure of one-sided abrupt junction serves as a zener diode in which an avalanche breakdown dominantly acts, thus allowing ensuring a high breakdown voltage.

In this embodiment, between the first contact portion C1 and the second contact portion C2, the N⁺-type well region 82 is formed to extend to the first contact portion C1 side with respect to the middle of the first contact portion C1 and the second contact portion C2 from the second contact portion C2. In other words, a width D3 of the N⁺-type well region 82 between the first contact portion C1 and the second contact portion C2 is formed to be a width of 0.5 times or more of the distance D2 between the first contact portion C1 and the second contact portion C2. In other words, the N⁺-type well region 82 extends to the first opening portion OP1 side exceeding the middle line between the first opening portion OP1 and the second opening portion OP2 along the lower surface of the composite substrate 10.

This allows increasing the voltage (withstand voltage) with which an avalanche breakdown occurs in the diode structure unit 80. According to the inventors, it was verified that when a reverse voltage (voltage in a direction from the second external electrode 22 to the first external electrode 21) was applied to the diode structure unit 80 of this embodiment, a breakdown voltage of -33.5 V was able to be obtained.

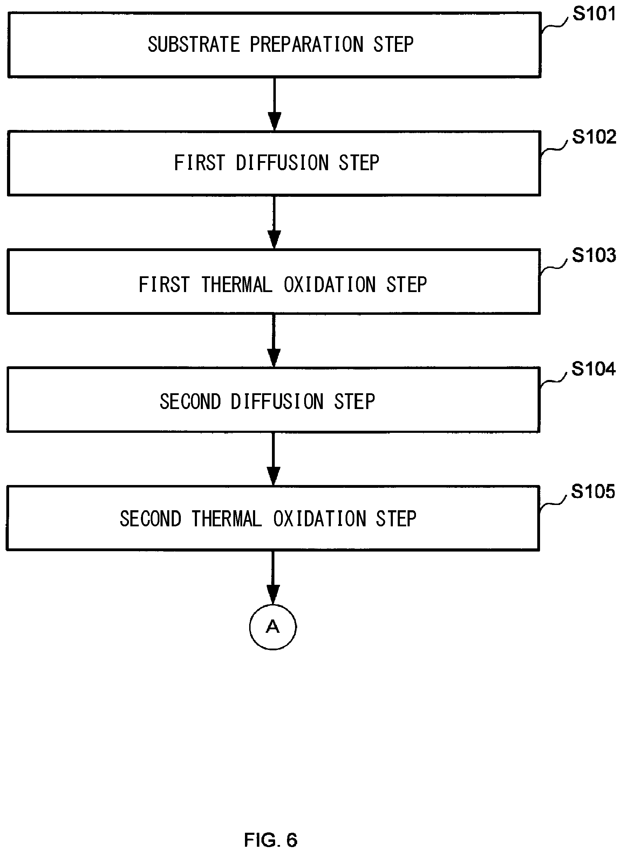

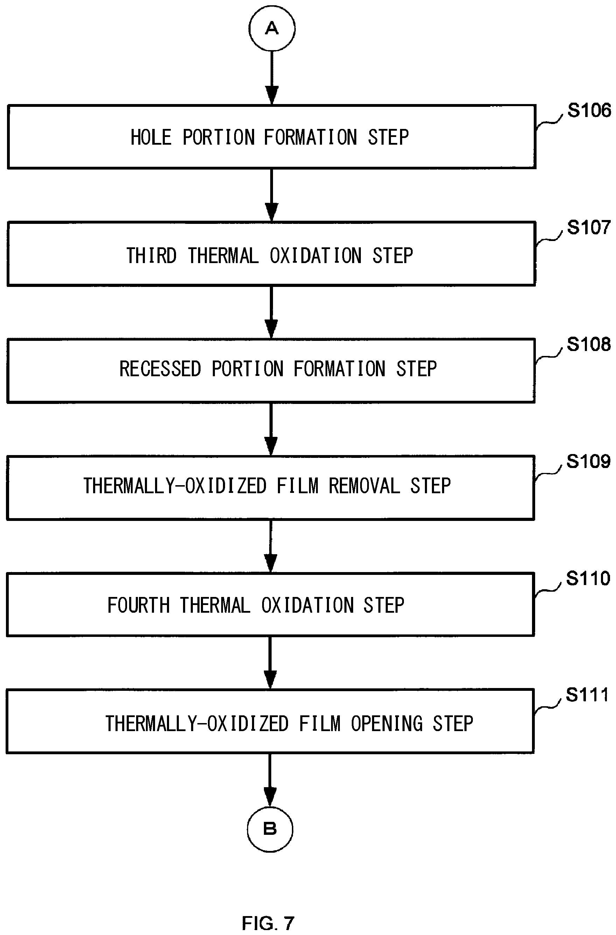

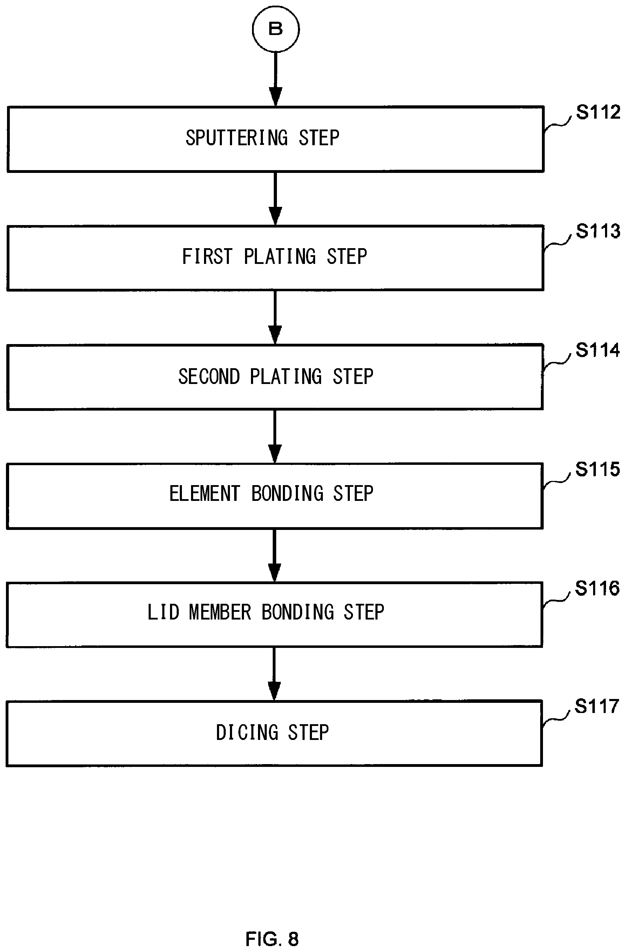

Next, with reference to FIG. 6 to FIG. 8 and FIG. 9 to FIG. 24, a manufacturing procedure of the semiconductor device 100 according to Embodiment 1 of this application will be described.

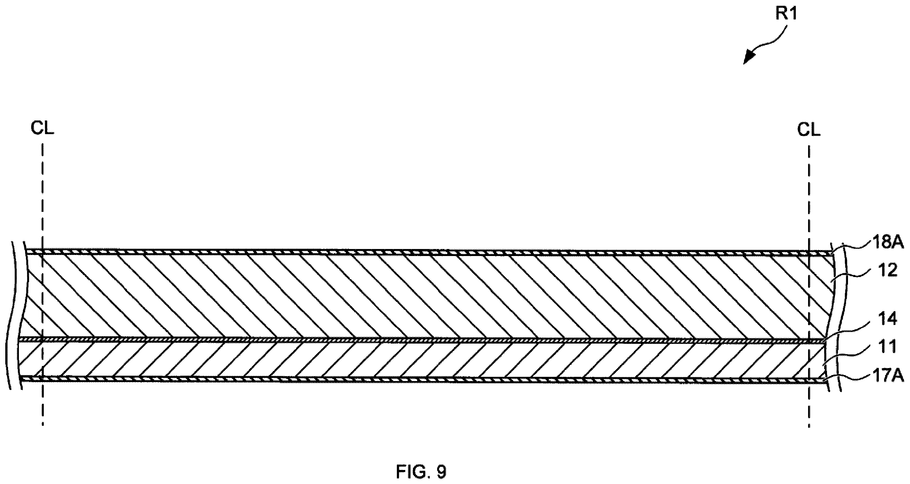

FIG. 6 to FIG. 8 are diagrams illustrating a manufacturing process of the semiconductor device 100 according to Embodiment 1 of the present invention. FIG. 9 to FIG. 24 are cross-sectional views of the semiconductor device 100 in respective steps of the manufacturing procedure illustrated in FIG. 6 to FIG. 8. In FIG. 9 to FIG. 24, similarly to FIG. 2, the cross-sectional surface taken along the line A-A illustrated in FIG. 1 is used for the description. Note that in this embodiment, as described above, the semiconductor device 100 is a WLP in which the semiconductor devices 100 are formed in a grid pattern on a wafer-shaped composite substrate 10. Accordingly, the composite substrate 10 includes a plurality of element mounting regions R1 defined by predetermined grid-like dividing lines CL on the wafer-shaped composite substrate 10. That is, the processes of the respective steps described below are continuously performed in a grid pattern on the wafer-shaped composite substrate 10. In the description of the process of each step below, a case of performing the process on one element mounting region R1 will be basically described.

First, as illustrated in FIG. 9, a substrate preparing step of preparing the composite substrate 10 in which the second substrate 12made of single crystal Si is bonded to the first substrate 11 made of single crystal Si via the buried oxide film 14 made of SiO₂ is performed (Step S101: substrate preparation step). On the upper surface of the first substrate 11 and the lower surface of the second substrate 12, thermally-oxidized films 17A and 18A are formed. In other words, the manufacturing method of the semiconductor device 100 includes a step of preparing the composite substrate 10 including the first substrate 11 of the first conductivity type made of single-crystal silicon.

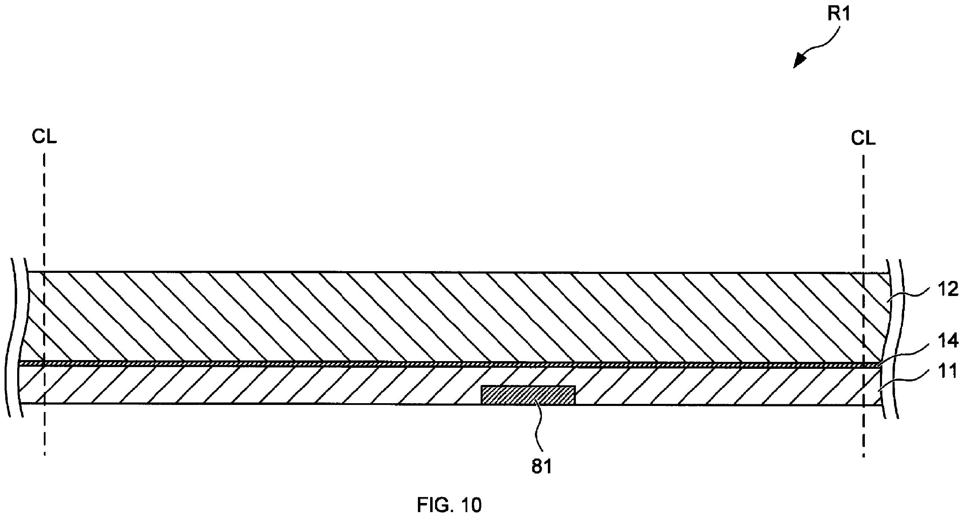

Next, as illustrated in FIG. 10, a first diffusion step of diffusing boron in the first region along the lower surface of the composite substrate 10 and forming the P-type well region 81 is performed (Step S102: first diffusion step). In this step, first, the first region of the thermally-oxidized film 17A formed on the lower surface of the composite substrate 10 is etched from the lower surface side using a buffered hydrofluoric acid (BHF), thereby exposing the lower surface of the first substrate 11 to the first region. Next, for example, a boron silicate glass (BSG) is formed on the lower surface of the composite substrate 10 under nitrogen atmosphere at 900°C for 1 h, thereby attaching boron to the first region of the first substrate 11. Then, the BSG and the thermally-oxidized films 17A and 18A are removed, and a drive-in heat treatment is performed under nitrogen atmosphere at 1100°C for 2.5 h, thereby diffusing the boron inside the first substrate 11. In other words, the manufacturing method of the semiconductor device 100 includes a first diffusion step of forming the P-type well region 81 of the second conductivity type different from the first conductivity type in the first region along the lower surface of the composite substrate 10. In the first diffusion step, solid-phase diffusion of the boron is caused inside the first substrate 11 by forming a boron silicate glass on the lower surface of the composite substrate 10 in the first region.

While the case where the solid phase diffusion in which the BSG is formed in the first region of the first substrate 11 is used is described in this embodiment, the method for diffusing boron in the first substrate 11 is not limited to this. Another diffusion method, for example, an ion implantation method of implanting boron ions from the lower side of the first region may be used.

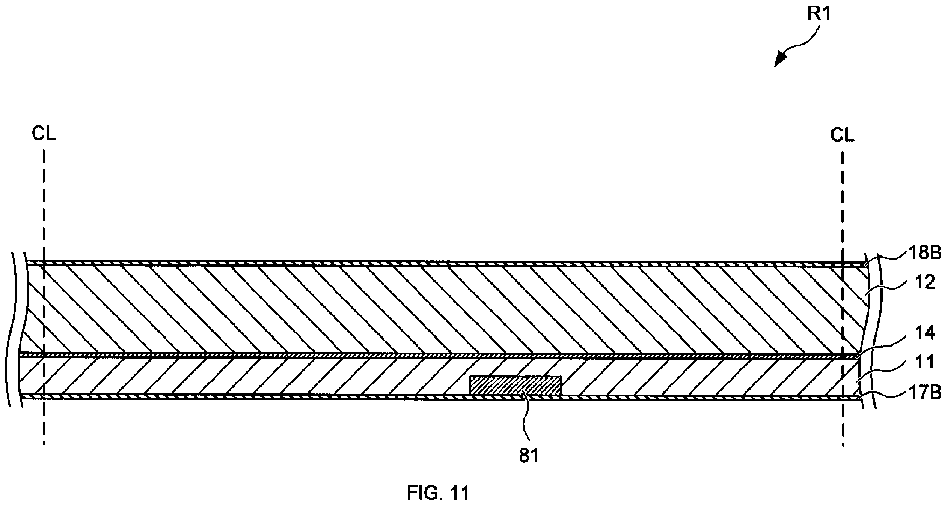

Next, as illustrated in FIG. 11, thermally-oxidized films 17B and 18B are formed on the lower surface of the first substrate 11 and the upper surface of the second substrate 12 (Step S103: first thermal oxidation step). In this step, a wet thermal oxidation treatment is performed on the wafer on which the P-type well region 81 has been formed under an atmosphere of oxygen (O₂) and water (H₂O) at 950°C for 2.5 h, thereby forming the thermally-oxidized films 17B and 18B.

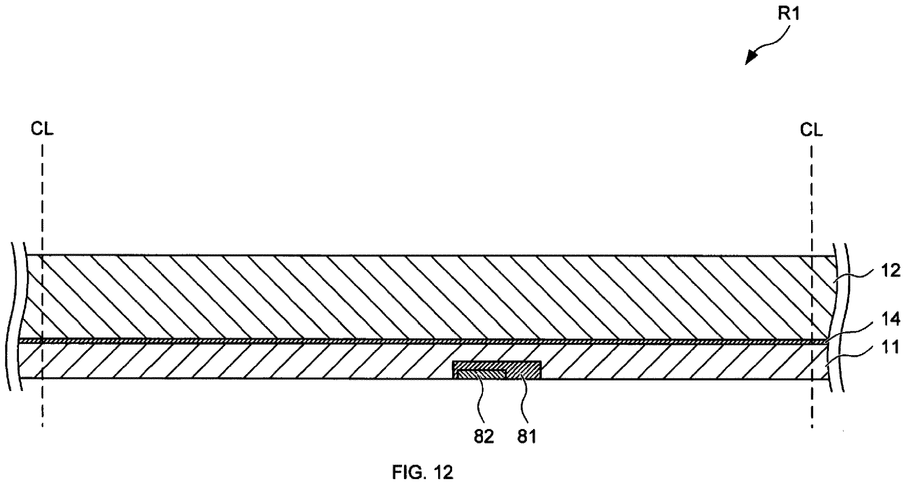

Next, as illustrated in FIG. 12, a second diffusion step of diffusing phosphorus in the second region along the lower surface of the composite substrate 10 in the first region and forming the N⁺-type well region 82 is performed (Step S104: second diffusion step). In this step, first, the second region of the thermally-oxidized film 17B formed on the lower surface of the composite substrate 10 is etched from the lower surface side using BHF, thereby exposing the lower surface of the P-type well region 81 to the second region. Next, for example, a phosphorus silicate glass (PSG) is formed on the lower surface of the composite substrate 10 under nitrogen atmosphere at 900°C for 1 h, thereby attaching phosphorus to the second region inside the P-type well region 81. Then, the PSG and the thermally-oxidized films 17B and 18B are removed, and a drive-in heat treatment is performed under nitrogen atmosphere at 1100°C for 2.5 h, thereby diffusing the phosphorus inside the P-type well region 81. In other words, the manufacturing method of the semiconductor device 100 includes a second diffusion step of forming the N⁺-type well region 82 of the first conductivity type in the second region along the lower surface of the composite substrate 10 inside the P-type well region 81. In the second diffusion step, solid-phase diffusion of the phosphorus is caused inside the first substrate 11 by forming a phosphorus silicate glass on the lower surface of the composite substrate 10 in the second region.

Similarly to Step S102, while the case where the solid phase diffusion in which the PSG is formed in the second region of the P-type well region 81 is used is described also in this embodiment, another diffusion method, for example, an ion implantation method of implanting phosphorus ions from the lower side of the second region may be used. In other words, in the first diffusion step and the second diffusion step, dopants are diffused inside the composite substrate 10 from the lower surface of the composite substrate 10 using the ion implantation method.

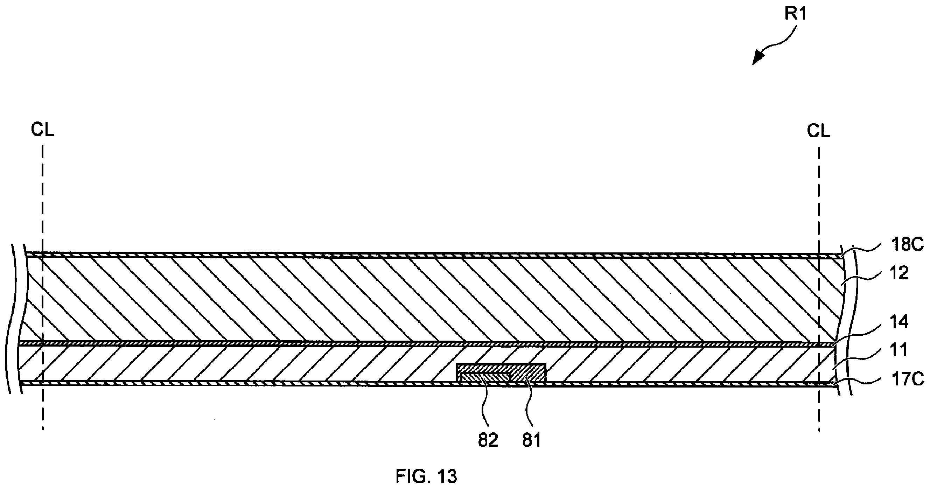

Next, as illustrated in FIG. 13, thermally-oxidized films 17C and 18C are formed on the lower surface of the first substrate 11 and the upper surface of the second substrate 12 (Step S105: second thermal oxidation step). In this step, a wet thermal oxidation treatment is performed on the wafer on which the P-type well region 81 has been formed under an atmosphere of oxygen (O₂) and water (H₂O) at 950°C for 2.5 h, thereby forming the thermally-oxidized films 17C and 18C.

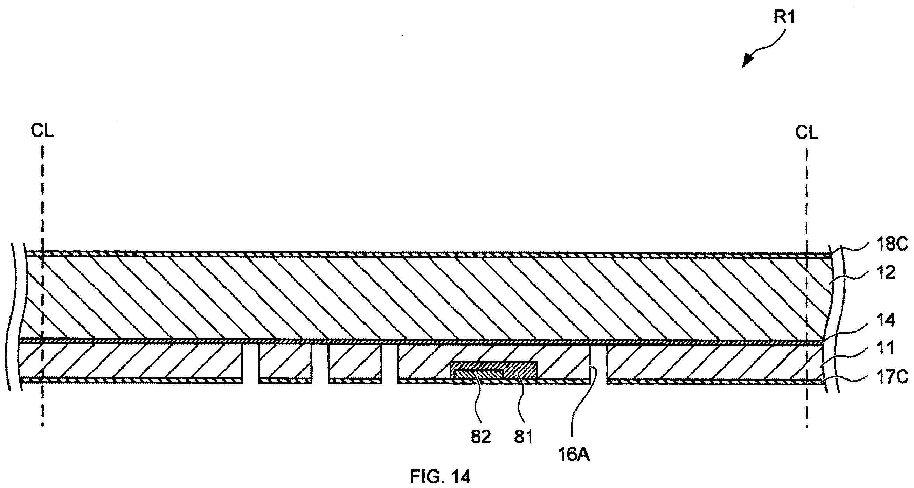

Next, as illustrated in FIG. 14, a hole portion formation step of performing an etching from the lower surface side of the composite substrate 10 and forming a plurality of columnar hole portions 16A that serve as the plurality of through holes 16 in the following steps is performed (Step S106: hole portion formation step). In this step, the plurality of hole portions 16A are each formed from the lower surface side of the first substrate 11 by deep reactive ion etching (DRIE) with Bosch process. The DRIE is performed until the lower surface of the buried oxide film 14 is exposed at the plurality of hole portions 16A. At this time, the buried oxide film 14 functions as an etch stopper. In other words, the manufacturing method of the semiconductor device 100 includes a hole portion formation step of forming a plurality of columnar hole portions 16A from the lower surface in the region excluding the P-type well region 81 in the lower surface of the composite substrate 10.

The plurality of hole portions 16A are formed in each of regions which are spaced from the P-type well region 81 and correspond to the cathode electrode 41 and the anode electrode 42 of the semiconductor element 40 in an element mounting step described later. Although not illustrated, this step includes steps of applying a photoresist over the lower surface of the composite substrate 10, exposing the photoresist for removing respective regions of the plurality of hole portions 16A and removing the photoresist, and etching the first substrate 11 at the opening portions of the photoresist and removing the photoresist.

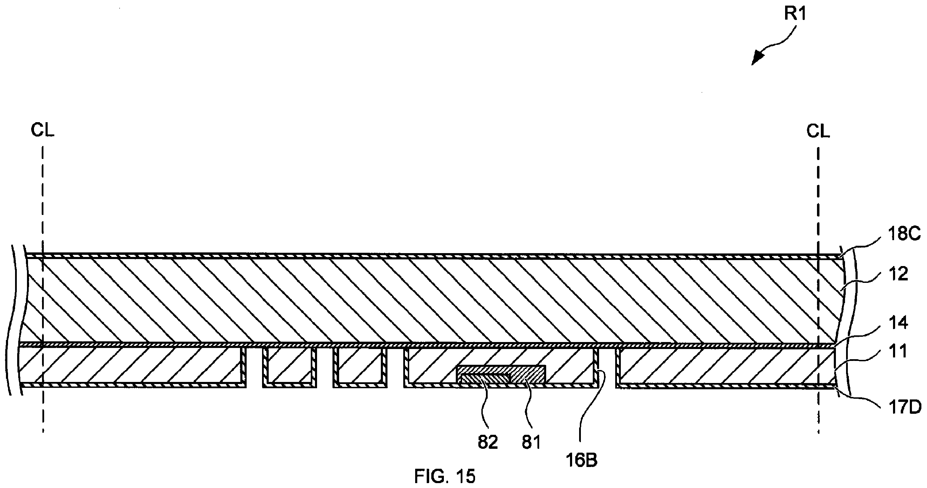

Next, as illustrated in FIG. 15, a thermally-oxidized film 17D is formed on the inner side surfaces of the plurality of hole portions 16A (Step S107: third thermal oxidation step). In this step, a wet thermal oxidation treatment is performed on the wafer on which the plurality of hole portions 16A have been formed under an atmosphere of oxygen (O₂) and water (H₂O) at 950°C for 2.5 h, thereby forming the thermally-oxidized film 17D on the inner side surfaces of the plurality of hole portions 16A. In this step, by forming the thermally-oxidized film 17D on the inner side surfaces, the plurality of hole portions 16A are formed into a plurality of hole portions 16B.

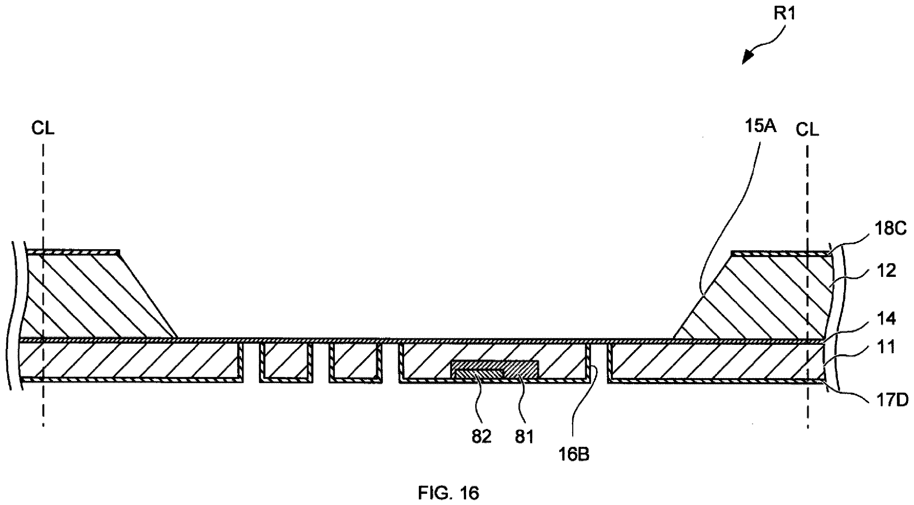

Next, as illustrated in FIG. 16, an etching is performed from the upper surface side of the composite substrate 10, thereby forming the recessed portion at the upper surface of the composite substrate 10 (Step S108: recessed portion formation step). In this step, an upper surface opening portion 15A is formed in the upper surface of the second substrate 12 by a crystal anisotropic wet etching using a tetramethylammonium hydroxide aqueous solution (TMAH). In the formation of the upper surface opening portion 15A, the etching is performed from the upper surface of the second substrate 12 by penetrating the second substrate until the upper surface of the buried oxide film 14 is exposed. In the formation of the upper surface opening portion 15A, a region including the regions in which the plurality of respective hole portions 16A have been formed is formed as a bottom surface of the recessed portion. The etching is performed such that the inner side surface of the upper surface opening portion 15A becomes a (111) crystal face of single-crystal silicon as the second substrate 12. This step includes steps of applying a photoresist over the upper surface of the second substrate 12, exposing the photoresist for removing regions of the respective recessed portions and removing the photoresist, and etching the thermally-oxidized film 18B and the second substrate 12 at the opening portions of the photoresist and removing the photoresist.

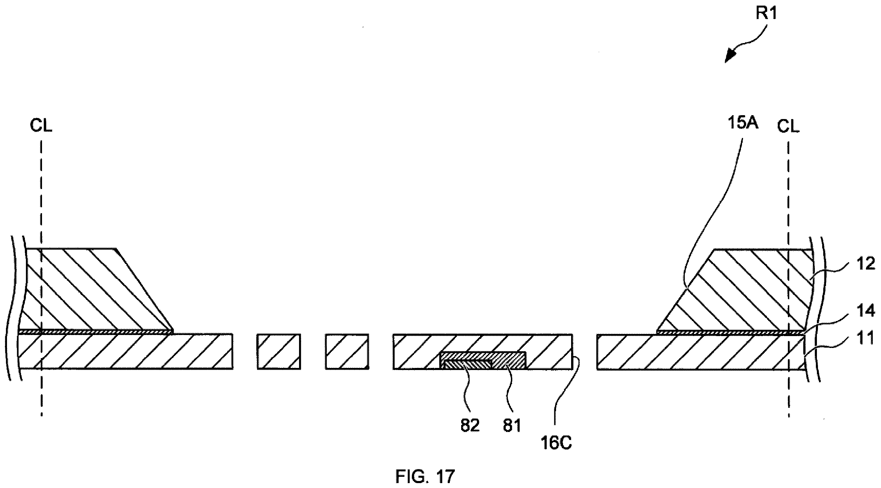

Next, as illustrated in FIG. 17, the thermally-oxidized film 17D formed on the first substrate 11, the thermally-oxidized film 18C formed on the second substrate 12, and the buried oxide film 14 exposed on the bottom surface of the upper surface opening portion 15A are removed (Step S109: thermally-oxidized film removal step). In this step, these oxidized films are removed using BHF. Thus, the buried oxide film 14 exposed on the bottom surface of the upper surface opening portion 15A is removed, thereby causing each of the plurality of hole portions 16B to be communicated with the bottom surface of the upper surface opening portion 15A.

In this step, the plurality of hole portions 16B are formed into a plurality of through holes 16C by removing the thermally-oxidized film 17D formed on the inner side surfaces and causing the bottom surface of the upper surface opening portion 15A to be communicated. That is, Step S108 and Step S109 are performed as a cavity formation step of forming a cavity having a bottom surface communicated with a plurality of through holes 16C at the composite substrate 10. In other words, the manufacturing method of the semiconductor device 100 includes a cavity formation step of forming a recessed portion from the upper surface of the composite substrate 10 such that the recessed portion has a region including a plurality of hole portions 16B as a bottom surface, and the bottom surface is communicated with the plurality of hole portions 16B.

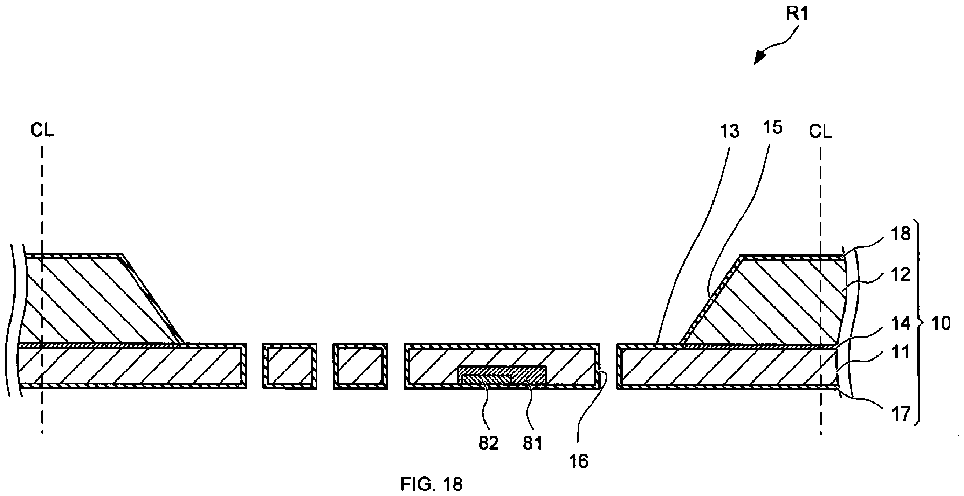

Next, as illustrated in FIG. 18, the thermally-oxidized film 17 and 18 are formed on the exposed surface of the first substrate 11 and the exposed surface of the second substrate 12 (Step S110: fourth thermal oxidation step). Specifically, the thermally-oxidized film 17 is formed on the lower surface of the first substrate 11, the upper surface of the first substrate 11 exposed on the bottom surface of the upper surface opening portion 15A, and the respective inner side surfaces of the plurality of through holes 16. The thermally-oxidized film 18 is formed on the upper surface of the second substrate 12 and the inner side surface of the upper surface opening portion 15A. In this step, a wet thermal oxidation treatment is performed on the wafer on which the thermally-oxidized films 17D and 18C have been removed under an atmosphere of oxygen (O₂) and water (H₂O) at 950°C for 2.5 h, thereby forming the thermally-oxidized films 17 and 18 on the exposed surface of the first substrate 11 and the exposed surface of the second substrate 12.

In this step, the plurality of through holes 16C are formed into the plurality of through holes 16 by forming the thermally-oxidized film 17 on the inner side surfaces. The upper surface opening portion 15A is formed into the upper surface opening portion 15 by forming the thermally-oxidized film 18 on the inner side surface. Thus, a space surrounded by the first substrate 11 and the upper surface opening portion 15 functions as a cavity of the composite substrate 10.

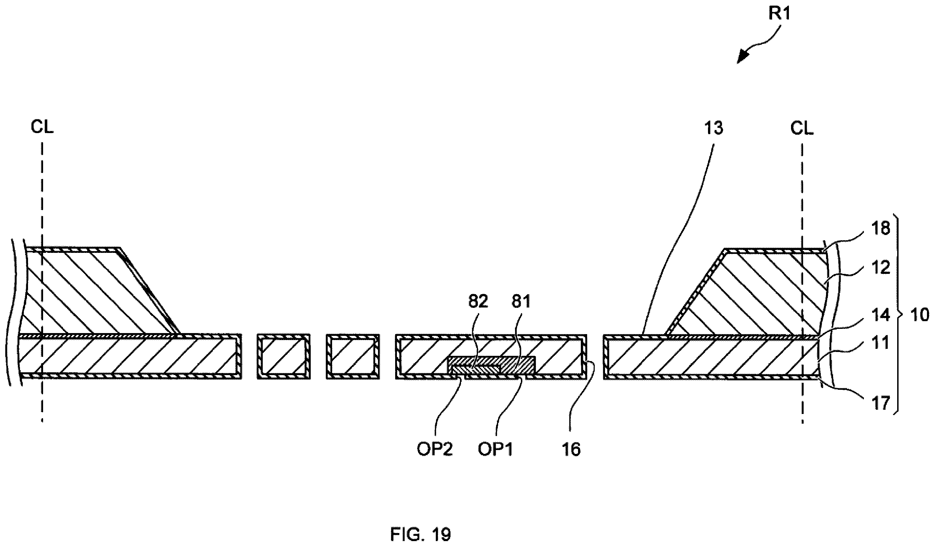

Next, as illustrated in FIG. 19, the first opening portion OP1 and the second opening portion OP2 are formed in respective regions mutually spaced in the thermally-oxidized film 17 formed on the lower surface of the first substrate 11 (Step S111: thermally-oxidized film opening step). In this step, the first opening portion OP1 and the second opening portion OP2 are opened at the thermally-oxidized film 17 so as to expose the respective lower surfaces of the P-type well region 81 and the N⁺-type well region 82. In this step, these oxidized films are removed using BHF.

Step S110 and Step S111 described above are performed as a thermally-oxidized film formation step of forming the thermally-oxidized film 17 provided with the first opening portion OP1 and the second opening portion OP2 on the lower surface of the composite substrate 10. In other words, the manufacturing method of the semiconductor device 100 includes a thermally-oxidized film formation step of forming the thermally-oxidized film 17 provided with the first opening portion OP1 from which the P-type well region 81 is exposed and the second opening portion OP2 from which the N⁺-type well region 82 is exposed in the lower surface of the composite substrate 10.

Note that in the second diffusion step of Step S104, the N⁺-type well region 82 is formed as illustrated in FIG. 5 such that the N⁺-type well region 82 extends exceeding the middle point between the first opening portion OP1 and the second opening portion OP2 on the thermally-oxidized film 17 in the thermally-oxidized film opening step of Step S111. In other words, in the second diffusion step, the N⁺-type well region 82 is formed to extend to the first opening portion OP1 side exceeding the middle line between the first opening portion OP1 and the second opening portion OP2 along the lower surface of the composite substrate 10.

By the wet thermal oxidation treatments in the first to the fourth thermal oxidation steps of Steps S103, S105, S107, and S110, as illustrated in FIG. 5, boron is segregated at the proximity of the lower surface side of the P-type well region 81, thereby forming the P⁺ segregation layer 81H. In other words, after forming the P-type well region 81 and the N⁺-type well region 82 in the first diffusion step and the second diffusion step, respectively, the thermally-oxidized films 17B, 17C, 17D, and 17 are formed on the respective lower surfaces of the P-type well region 81 and the N⁺-type well region 82 by the wet thermal oxidation, and the P⁺ segregation layer 81H is formed in one region facing the first opening portion OP1 of the P-type well region 81 with a carrier density higher than that of the other region.

Next, a Ti seed layer and a Cu seed layer are formed from the lower surface side of the first substrate 11 (Step S112: sputtering step). In this step, a Ti seed layer and a Cu seed layer are formed in this order from the lower surface side of the thermally-oxidized film 17 over the whole lower surface of the thermally-oxidized film 17 by sputtering film formation. The titanium seed layer and the copper seed layer are laminated to be formed in this order from the respective lower surfaces of the P-type well region 81 and N⁺-type well region 82 at the first opening portion OP1 and the second opening portion OP2 so as to cover the well regions exposed from the respective opening portions. At the plurality of through holes 16, the titanium seed layer and the copper seed layer are laminated to be formed in this order on a part of the inner side surface in the lower surface side of each of the plurality of through holes 16.

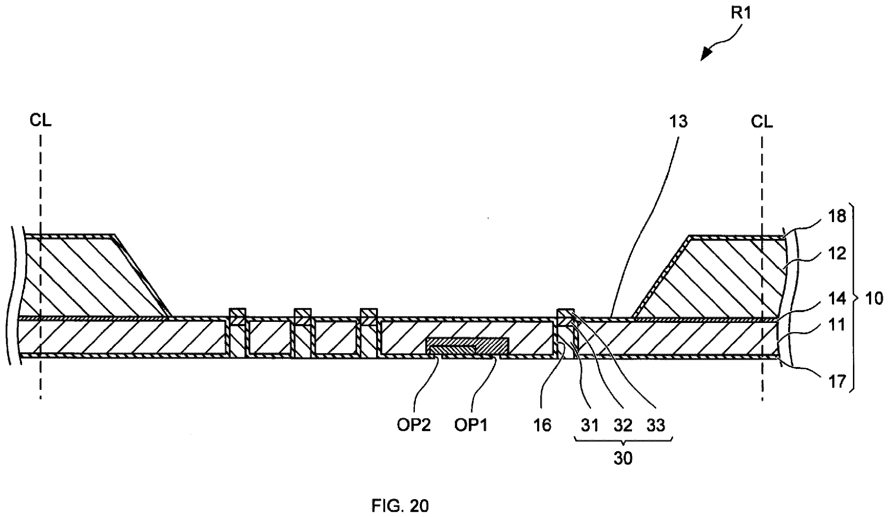

Next, as illustrated in FIG. 20, a through electrode formation step of forming the plurality of through electrodes 30 including the Cu layer 31, the Ni layer 32, and the AuSn layer 33 inside the plurality of respective through holes 16 is performed (Step S113: first plating step). In this step, the lower surface of the composite substrate 10 is masked, and the Cu layer 31, the Ni layer 32, and the AuSn layer 33 are formed inside each of the plurality of through holes 16 by electrolytic plating in the order of Cu, Ni, and AuSn from the lower surface of the composite substrate 10. The plurality of through electrodes 30 are formed such that the AuSn layer 33 projects from the thermally-oxidized film 17. In other words, the manufacturing method of the semiconductor device 100 includes a through electrode formation step of forming a plurality of columnar through electrodes 30 that fill inside the plurality of respective through holes 16 and project from the bottom surface of the cavity by electrolytic plating.

With the plurality of through electrodes 30, the upper surface of the first substrate 11 that is the bottom surface of the upper surface opening portion 15 functions as the element mounting surface 13. Then, by removing the mask of the lower surface of the first substrate 11, the Cu layers 31 of the plurality of respective through electrodes 30 are exposed on the lower surface of the first substrate 11.

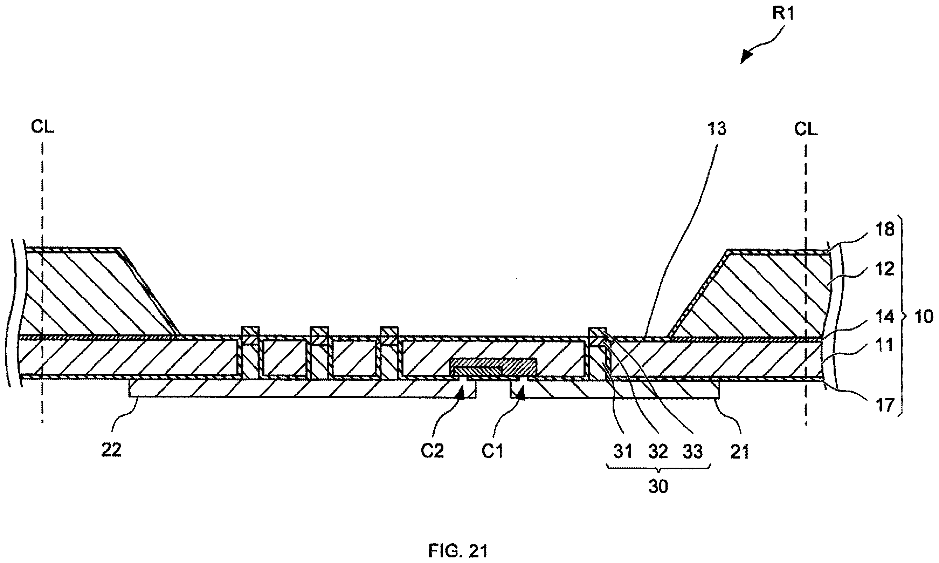

Next, as illustrated in FIG. 21, the first external electrode 21 and the second external electrode 22 are formed on the lower surface of the composite substrate 10 (Step S114: second plating step). In this step, first, masking is performed with a resist opened at formation regions of the first external electrode 21 and the second external electrode 22 on the lower surface of the composite substrate 10. Next, the Ni plated layers 21C and 22C and the AuSn plated layers 21D and 22D are laminated in this order on the respective lower surfaces of the copper seed layer exposed from the opening region of the resist and the Cu layers 31 of the plurality of through electrodes 30 using electrolytic plating. This causes the Ni plated layers 21C and 22C to be electrically in contact with the respective lower surfaces of the Cu layers 31 that are the lower surfaces of the plurality of through electrodes 30.

Then, the resist is removed, and the Ti seed layer and the copper seed layer remaining in a region excluding the regions in which the Ni plated layers 21C and 22C and the AuSn plated layers 21D and 22D are formed on the lower surface of the thermally-oxidized film 17 are removed. Thus, as illustrated in FIG. 5, the Ti seed layer and the copper seed layer are formed into the mutually spaced Ti seed layers 21A and 22A and the mutually spaced Cu seed layers 21B and 22B. That is, in this step, the first external electrode 21 and the second external electrode 22 that are a pair of electrically insulated external electrodes are formed.

Step S112 and Step S114 described above are performed as an external electrode formation step of forming the first external electrode 21 and the second external electrode 22 that are a pair of mutually spaced external electrodes formed by laminating the Ti seed layers 21A and 22A, the Cu seed layers 21B and 22B, and the Ni plated layers 21C and 22C in this order from the lower surface of the composite substrate 10. In other words, the manufacturing method of the semiconductor device 100 includes an external electrode formation step of forming the first external electrode 21 in contact with the P-type well region 81 at the first opening portion OP1 and the second external electrode 22 that is spaced from the first external electrode 21 and in contact with the N⁺-type well region 82 at the second opening portion OP2 on the lower surface of the thermally-oxidized film 17. In the external electrode formation step, the first external electrode 21 and the second external electrode 22 are formed by laminating the Ti seed layers 21A and 22A, the Cu seed layers 21B and 22B, and the Ni plated layers 21C and 22C in this order from the lower surface of the composite substrate 10 at the first opening portion OP1 and the second opening portion OP2, respectively.

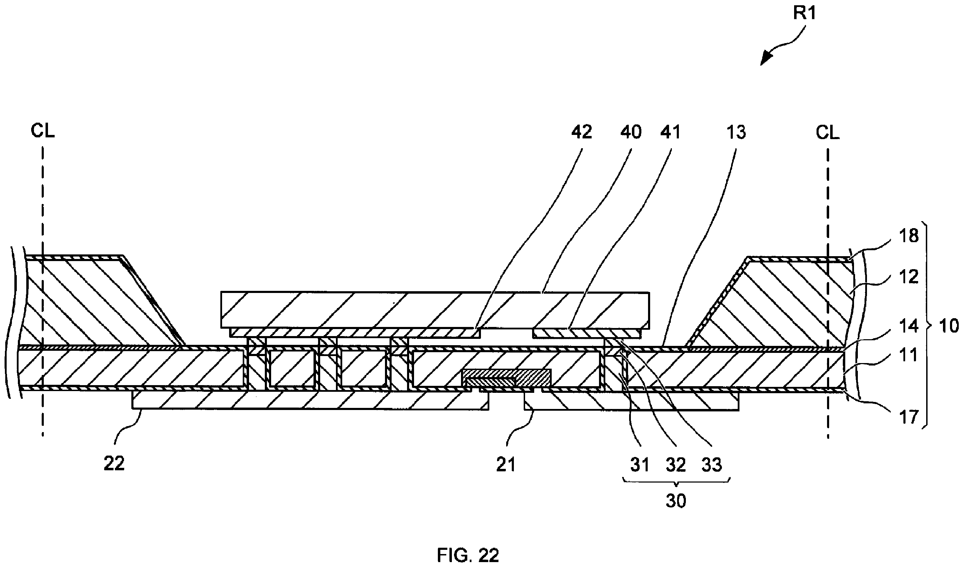

Next, as illustrated in FIG. 22, a die bonding step of setting the composite substrate 10 to a die bonding apparatus and placing the semiconductor element 40 on the element mounting surface 13 is performed (Step S115: element bonding step). In this step, positioning is performed such that the cathode electrode 41 of the semiconductor element 40 is corresponded to the through electrode 30 electrically connected to the first external electrode 21, and the anode electrode 42 of the semiconductor element 40 is corresponded to the through electrode 30 electrically connected to the second external electrode 22, and thus the semiconductor element 40 is placed. Then, the wafer on which the semiconductor element 40 has been placed is heated under nitrogen (N₂) atmosphere at 340°C for 30 seconds to melt the AuSn layers 33 of the plurality of through electrodes 30, thereby bonding the plurality of respective through electrodes 30 to the cathode electrode 41 and the anode electrode 42 of the semiconductor element 40. In other words, the manufacturing method of the semiconductor device 100 includes a die bonding step of placing the semiconductor element 40 on the bottom surface of the recessed portion.

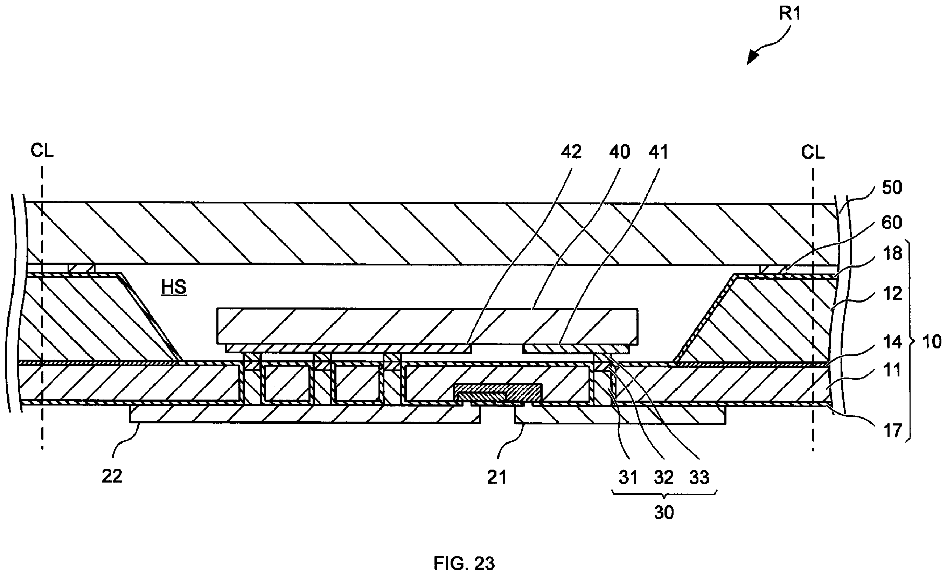

Next, as illustrated in FIG. 23, a lid member bonding step of bonding the lid member 50 to the upper surface of the second substrate 12 via the fritted glass layer 60 is performed (Step S116: lid member bonding step). In this step, first, the lid member 50 in which the fritted glass layer 60 is preliminarily formed on the surface opposed to the upper surface of the second substrate 12 is prepared. The fritted glass layer 60 is printed on the surface opposed to the second substrate 12 of the wafer-shaped lid member 50 so as to surround the upper surface opening portion 15, and has been calcined under oxygen (O₂) atmosphere at a temperature of about 500°C for one hour. The lid member 50 is positioned at a position surrounding the upper surface opening portion 15 and not overlapping with the dividing lines CL of the composite substrate 10, and placed.

Next, the composite substrate 10 on which the lid member 50 has been placed is irradiated with laser from above, thereby melting the fritted glass layer 60 to join the composite substrate 10 to the lid member 50. The laser is, for example, a laser light having a wavelength of near-infrared ray. The laser is irradiated on the fritted glass layer 60 under N₂ atmosphere, and the fritted glass layer 60 is locally heated to be melted, thereby bonding it to the composite substrate 10. At this time, as described in FIG. 4, the melted fritted glass layer 60 and the thermally-oxidized film 18 on the upper surface of the second substrate 12 are inter-diffused and form the inter-diffusion layer 70. Thus, the housing space HS in which the cavity is internally filled with N₂ as an inert gas and airtightly sealed is formed. In other words, the manufacturing method of the semiconductor device 100 includes a lid member bonding step of bonding the lid member 50 to the upper surface of the composite substrate 10 by placing the lid member 50 that includes the fritted glass layer 60 on one surface opposed to the upper surface of the composite substrate 10 and is made of a glass on the upper surface of the composite substrate 10 so as to cover the recessed portion, and scanning the fritted glass layer 60 with a laser from above along the periphery of the recessed portion.

In this step, for irradiation conditions of the laser, various kinds of conditions are set for forming the remaining thermally-oxidized film 18R after the formation of the interdiffusion layer 70. That is, the irradiation conditions of the laser are set to obtain the structure in which the remaining thermally-oxidized film 18R, the interdiffusion layer 70, and the fritted glass layer 60 are laminated in this order from the upper surface of the second substrate 12 at the bonding portion between the second substrate 12 and the fritted glass layer 60.

In this embodiment, the fritted glass layer 60 surrounding the cavity is scanned by laser along the periphery of the cavity. The scanning period by the laser is about 2 to 3 seconds for one semiconductor device 100. With the fusion bonding of the fritted glass layer 60 by the irradiation with laser, the bonding portion of the fritted glass layer 60 is locally heated in a short time, thereby bonding the fritted glass layer 60. This allows avoiding remelting due to an excessive heating of the AuSn layer 33 of the through electrode 30 that is a bonding portion with the semiconductor element 40, thus allowing suppressing a manufacturing failure, such as a position shift of the semiconductor element 40.

The inside of the cavity is a space filled with N₂ gas, and the thermal conductivity is considerably small compared with the composite substrate 10 containing single crystal Si as a main material. The heat of the element mounting surface 13 is released to the lower surface side of the composite substrate 10 (for example, a placement table of a laser irradiation device) due to the high thermal conductivity of the single crystal Si, and thus the excessive heating of the AuSn layer 33 can be more suppressed. According to a validation by the inventors, the temperature of the element mounting surface 13 at the irradiation with laser was 250°C or less.

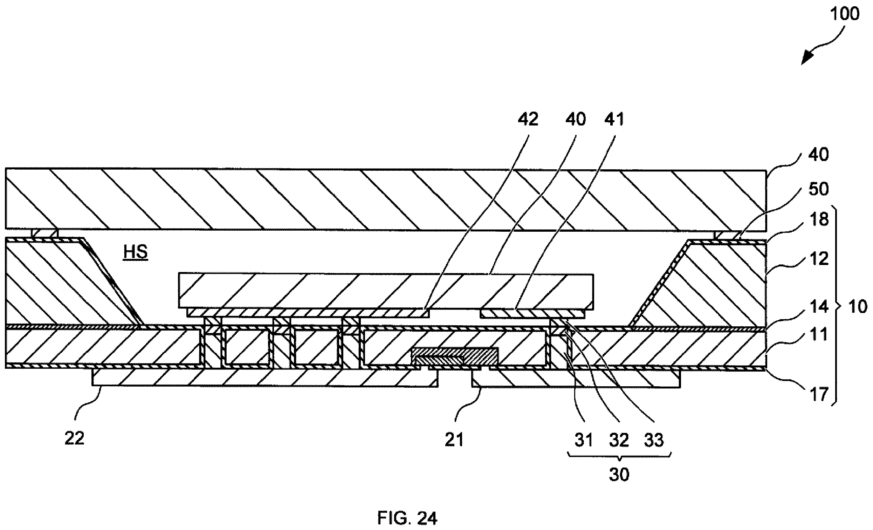

Next, as illustrated in FIG. 24, the composite substrate 10 to which the lid member 50 has been bonded is set to a dicing apparatus, and the composite substrate 10 and the lid member 50 are cut along the dividing lines CL to be individualized (Step S 117: dicing step). Thus, the wafer is diced into individual units of the semiconductor device 100, thereby manufacturing a plurality of semiconductor devices 100.

According to this embodiment, the semiconductor device 100 includes the diode structure unit 80 formed in the region along the lower surface of the composite substrate 10 inside the composite substrate 10. The diode structure unit 80 includes the P-type well region 81 of the second conductivity type in the first region over the first external electrode 21 and the second external electrode 22 on the lower surface of the composite substrate 10. In the P-type well region 81, P-type impurities, such as boron (B), are diffused from the lower surface side of the first substrate 11.

The diode structure unit 80 includes, for example, the N⁺-type well region 82 of the first conductivity type in the second region in the first region on the lower surface of the first substrate 11. In the N⁺-type well region 82, N-type impurities, such as phosphorus (P), are diffused from the lower surface side of the first substrate 11. The diode structure unit 80 functions as a zener diode connected to the semiconductor element 40 in parallel with reversed polarity between the first external electrode 21 and the second external electrode 22.

The diode structure unit 80 is a zener diode having a structure of one-sided abrupt junction in which the carrier density is high in the N⁺-type well region 82 compared with the P-type well region 81, and is a zener diode in which an avalanche breakdown dominantly acts when the overvoltage is applied in the direction from the N⁺-type well region 82 to the P-type well region 81. In the diode structure unit 80, the width D3 of the N⁺-type well region 82 between the first contact portion C1 and the second contact portion C2 is formed to be a width of 0.5 times or more of the distance D2 between the first contact portion C1 and the second contact portion C2. With these configurations, the diode structure unit 80 can function as a zener diode having a high breakdown voltage.

The lower surface of the diode structure unit 80 is covered with the thermally-oxidized film 17 and insulated between the electrodes of the first external electrode 21 and the second external electrode 22. With this configuration, in the mounting to the mounting substrate, the semiconductor device 100 can suppress the leak current to the diode structure unit 80 when the first external electrode 21 and the second external electrode 22 are bonded using a molten metal, such as AuSn or a solder.

Between the P-type well region 81 of the diode structure unit 80 and the first substrate 11, a depletion layer due to an internal electric field is formed, and the P-type well region 81 and the first substrate 11 are substantially mutually insulated. With this configuration, the first substrate 11 is substantially insulated from the P-type well region 81 and in an electrically floating state. This allows the semiconductor device 100 to suppress a leak current from the side surface of the first substrate 11 to another adjacent semiconductor device on the mounting substrate when an overvoltage is applied on the mounting substrate.

As described above, the semiconductor device 100 of this embodiment can provide the semiconductor device 100 capable of avoiding a short circuit caused by a molten metal at a heating treatment of a bonding layer, and capable of suppressing a leak current to another adjacent semiconductor device when an overvoltage is applied after being mounted to a mounting substrate, and can provide a method for manufacturing the semiconductor device 100.

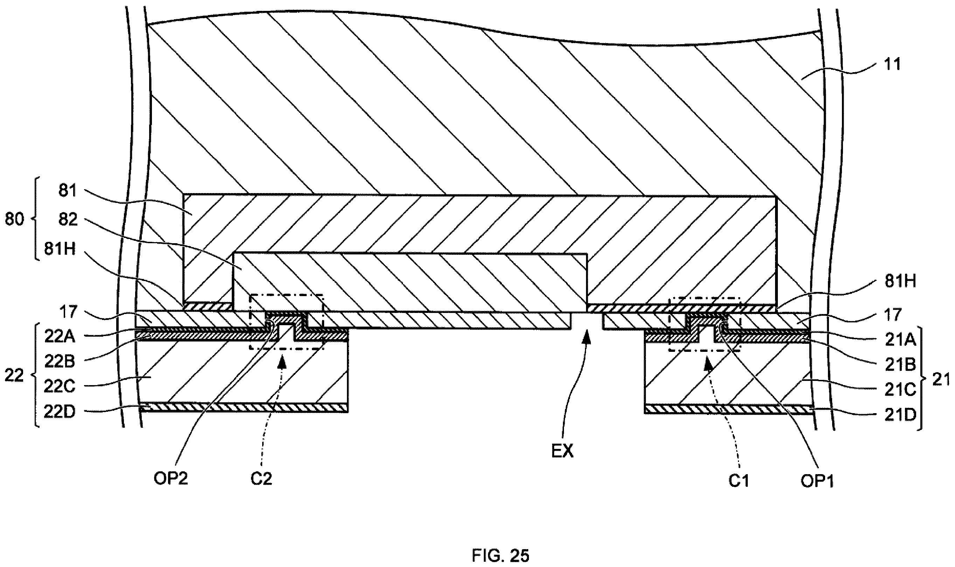

FIG. 25 is an enlarged cross-sectional view of a diode structure unit 80 of a semiconductor device 100 according to Embodiment 2 of the present invention. FIG. 25 is an enlarged cross-sectional view at a position corresponding to the zener diode part illustrated in FIG. 2.

The semiconductor device 100A has a configuration basically similar to that of the semiconductor device 100 of Embodiment 1, and has a similar appearance. The semiconductor device 100A is different from Embodiment 1 in that an interface opening portion EX opened at a region corresponding to a bonding interface between the P-type well region 81 and the N⁺-type well region 82 is provided in the thermally-oxidized film 17 formed on the lower surface of the diode structure unit 80.

In Embodiment 1, an overvoltage, such as a static electricity, is applied in the direction from the N⁺-type well region 82 as a cathode to the P-type well region 81, thereby causing the avalanche breakdown in the diode structure unit 80 to flow a current. At this time, the thermo-electrons due to the avalanche breakdown are trapped by the thermally-oxidized film 17 in the region corresponding to the bonding interface between the P-type well region 81 and the N⁺-type well region 82, thus possibly causing the thermally-oxidized film 17 to be charged. When the thermo-electrons are trapped by the thermally-oxidized film 17 at the proximity of the bonding interface between the P-type well region 81 and the N⁺-type well region 82, the avalanche breakdown is easily caused in the diode structure unit 80, and the effective breakdown voltage of the diode structure unit 80 is possibly reduced. That is, when the overvoltage is applied to the semiconductor device 100 multiple times, the breakdown voltage of the diode structure unit 80 is gradually reduced, and when the breakdown voltage falls below the driving voltage of the semiconductor element 40, the driving of the semiconductor element 40 is possibly affected.

In Embodiment 2, with the interface opening portion EX provided in the thermally-oxidized film 17 in the region corresponding to the bonding interface between the P-type well region 81 and the N⁺-type well region 82, trapping of the thermoelectrons by the thermally-oxidized film 17 can be suppressed when the avalanche breakdown is caused in the diode structure unit 80. That is, even when the overvoltage is applied to the semiconductor device 100 multiple times, the breakdown voltage of the diode structure unit 80 can be kept at a desired voltage value.

Inside the interface opening portion EX, exposed surfaces of the P-type well region 81 and the N⁺-type well region 82 are insulated by only a natural oxide film of Si. Therefore, an insulating property inside the interface opening portion EX is lower than an insulating property in the region in which the thermally-oxidized film 17 is formed. However, in considering the width of the depletion layer formed at the bonding interface between the P-type well region 81 and the N⁺-type well region 82, since the opening width of the interface opening portion EX is about several µm, there is a low possibility that a bonding member, such as a solder, enters when the semiconductor device 100 is mounted to the mounting substrate and the bonding member contacts the P-type well region 81 and the N⁺-type well region 82.

The semiconductor device 100A of Embodiment 2 has a configuration similar to Embodiment 1 excluding the interface opening portion EX. That is, since the depletion layer is formed at the interface between the P-type well region 81 and the first substrate 11, the diode structure unit 80 is substantially insulated from the first substrate 11.

Accordingly, Embodiment 2 also can provide the semiconductor device and a method for manufacturing the semiconductor device capable of avoiding a short circuit caused by a molten metal at a heating treatment of a bonding layer, and capable of suppressing a leak current to another semiconductor device when an overvoltage is applied on a mounting substrate.

In the embodiments, a case where the semiconductor element 40 mounted to the semiconductor device 100 is a light-emitting element that emits an ultraviolet light is described. However, the semiconductor element 40 mounted to the semiconductor device 100 is not limited to this. For example, the semiconductor element 40 may be another light-emitting element, such as a laser diode, and may be a light receiving element, such as a photodiode.

In the embodiments, a case where the semiconductor element 40 mounted to the semiconductor device 100 is a semiconductor element of two-terminal device with a pair of electrodes of an anode and a cathode is described. However, the semiconductor element 40 may be a semiconductor element of three-terminal device with three electrodes. For the external electrode provided to the semiconductor device 100, three electrodes may be disposed. In this case, the diode structure unit 80 can be appropriately disposed between the desired electrodes.

In the embodiments, a case where the lid member 50 is a light transmitting material that transmits a light having a desired wavelength is described. However, the lid member 50 is not limited to this, and the lid member 50 may be a lid member made of a metal or a ceramic when the semiconductor element 40 is an element not relating to a light. Even when the lid member 50 is made of a metal or a ceramic, bonding to the composite substrate 10 via a fritted glass allows airtightly sealing the housing space HS inside the cavity.

In the embodiments, a case where the semiconductor element 40 is disposed to be placed over the plurality of through electrodes 30 formed to project from the element mounting surface 13 is described. However, the placing method of the semiconductor element 40 is not limited to this. For example, block-shaped element mounting electrodes having upper surface shapes approximately similar to the lower surface shapes of the cathode electrode 41 and the anode electrode 42 of the semiconductor element 40 may be formed on the upper surface of the element mounting surface 13. In this case, a plurality of through electrodes are formed by filling a metal, such as Cu, inside the plurality of through holes 16 by plating, and plating is performed in the order of Ni and AuSn so as to contact the respective upper surfaces of the plurality of through electrodes, thus forming a pair of block-shaped element mounting electrodes. This allows self-alignment of the mounting position of the semiconductor element 40 in the element bonding step.

## Claims

1. A semiconductor device comprising:
a substrate having a first conductivity type and made of a single-crystal silicon, the substrate having an upper surface and a lower surface on which thermally-oxidized films are formed, a first opening portion and a second opening portion being formed to be mutually spaced in the thermally-oxidized film formed on the lower surface, the substrate including a diode structure unit that includes a first well region and a second well region, the first well region being formed in a first region along the lower surface and being exposed at the first opening portion, the first well region having a second conductivity type different from the first conductivity type, the second well region being formed in a second region along the lower surface in the first region and being exposed at the second opening portion, the second well region having the first conductivity type;
a semiconductor element disposed on the substrate and including a semiconductor layer;
a first external electrode formed on a lower surface of the thermally-oxidized film and in contact with the first well region at the first opening portion; and
a second external electrode formed on the lower surface of the thermally-oxidized film, spaced from the first external electrode, and in contact with the second well region at the second opening portion, wherein
the second well region extends to the first opening portion side exceeding a middle line between the first opening portion and the second opening portion along the lower surface of the substrate.

2. The semiconductor device according to claim 1, wherein
the first external electrode and the second external electrode each include a titanium seed layer, a copper seed layer, and a nickel plated layer laminated in an order thereof from the lower surface of the substrate at the first opening portion and the second opening portion, respectively.

3. The semiconductor device according to claim 1 or 2, wherein
the second well region has a high concentration well region in one region facing the second opening portion, and a carrier density is higher in the one region than in another region.

4. The semiconductor device according to any one of claims 1 to 3, wherein
the diode structure unit is a zener diode or an avalanche diode.

5. The semiconductor device according to any one of claims 1 to 4, wherein
the first well region is doped with boron, and
the second well region is doped with phosphorus.

6. The semiconductor device according to any one of claims 1 to 5, wherein
the substrate is formed by bonding a plate-shaped first substrate and a second substrate, the first substrate has the first conductivity type and is made of a single-crystal silicon, the second substrate is disposed on the first substrate and provided with an opening having an inner side surface that forms a recessed portion with an upper surface of the first substrate, and
an oxidized film is formed on a surface in the second substrate side of the first substrate.

7. The semiconductor device according to any one of claims 1 to 6, wherein
the semiconductor element includes a pair of electrodes on a lower surface thereof,
the substrate is provided with a plurality of through holes penetrating from a bottom surface of the recessed portion to a back surface of the substrate in columnar shapes, and inner side surfaces of the plurality of through holes are covered with the thermally-oxidized film,
a plurality of columnar through electrodes are formed in the plurality of through holes, and the plurality of through electrodes fill the plurality of through holes of the substrate and project from the bottom surface, and
the plurality of through electrodes electrically connect the pair of respective electrodes of the semiconductor element to the first external electrode and the second external electrode.

8. The semiconductor device according to claim 7, wherein
the plurality of through electrodes are disposed at respective lattice points of an equilateral triangular grid on the bottom surface of the recessed portion.

9. The semiconductor device according to any one of claims 1 to 8, further comprising
a lid member made of a glass and being bonded to the upper surface of the substrate via a fritted glass layer, wherein
at a bonding portion of the substrate and the fritted glass layer, the thermally-oxidized film and a reaction layer of the thermally-oxidized film and the fritted glass layer are formed in an order thereof from a surface of the substrate between the substrate and the fritted glass layer.

10. The semiconductor device according to any one of claims 1 to 9, wherein
the semiconductor element is a light-emitting element that emits an ultraviolet light from the semiconductor layer.

11. A method for manufacturing a semiconductor device, comprising:
a step of preparing a substrate having a first conductivity type and made of a single-crystal silicon;
a first diffusion step of forming a first well region having a second conductivity type different from the first conductivity type in a first region along a lower surface of the substrate;
a second diffusion step of forming a second well region having the first conductivity type in a second region along the lower surface of the substrate in the first region;
a thermally-oxidized film formation step of forming a thermally-oxidized film on the lower surface of the substrate, the thermally-oxidized film being provided with a first opening portion at which the first well region is exposed and a second opening portion at which the second well region is exposed; and
an external electrode formation step of forming a first external electrode and a second external electrode on a lower surface of the thermally-oxidized film, the first external electrode being in contact with the first well region at the first opening portion, and the second external electrode being spaced from the first external electrode and in contact with the second well region at the second opening portion, wherein
in the second diffusion step, the second well region is formed to extend to the first opening portion side exceeding a middle line between the first opening portion and the second opening portion along the lower surface of the substrate.

12. The method for manufacturing a semiconductor device according to claim 11, wherein
in the external electrode formation step, the first external electrode and the second external electrode are each formed by laminating a titanium seed layer, a copper seed layer, and a nickel plated layer in an order thereof from the lower surface of the substrate at the first opening portion and the second opening portion, respectively.

13. The method for manufacturing a semiconductor device according to claim 11 or 12, wherein
in the first diffusion step, a boron silicate glass is disposed on the lower surface of the substrate in the first region to cause solid-phase diffusion of boron inside the substrate, and
in the second diffusion step, a phosphorus silicate glass is disposed on the lower surface of the substrate in the second region to cause solid-phase diffusion of phosphorus inside the substrate.

14. The method for manufacturing a semiconductor device according to any one of claims 11 to 13, wherein
in the first diffusion step and the second diffusion step, a dopant is diffused inside the substrate from the lower surface of the substrate using an ion implantation method.

15. The method for manufacturing a semiconductor device according to any one of claims 11 to 14, wherein
after forming the first well region and the second well region in the first diffusion step and the second diffusion step, respectively, the thermally-oxidized films are formed on respective lower surfaces of the first well region and the second well region by a wet thermal oxidation, a high concentration well region is formed in one region facing the first opening portion of the first well region, and a carrier density is higher in the one region than in another region.

16. The method for manufacturing a semiconductor device according to any one of claims 11 to 15, further comprising:
a hole portion formation step of forming a plurality of columnar hole portions from the lower surface in a region excluding the first region in the lower surface of the substrate;
a cavity formation step of forming a recessed portion from an upper surface of the substrate such that the recessed portion has a region including the plurality of hole portions as a bottom surface and the bottom surface is communicated with the plurality of hole portions; and
a through electrode formation step of forming a plurality of columnar through electrodes that fill inside the plurality of respective hole portions and project from the bottom surface of the cavity by electrolytic plating.

17. The method for manufacturing a semiconductor device according to any one of claims 11 to 16, further comprising:
a die bonding step of placing a semiconductor element on the bottom surface of the recessed portion; and
a lid member bonding step of bonding a lid member to the upper surface of the substrate by placing the lid member that includes a fritted glass layer on one surface opposed to the upper surface of the substrate and is made of a glass on the upper surface of the substrate so as to cover the recessed portion, and scanning the fritted glass layer with a laser from above along a periphery of the recessed portion.
